(19) Europäisches Patentamt
European Patent Office
Office européen des brevets

(11) **EP 1 746 874 A2**

(12) **EUROPEAN PATENT APPLICATION**

(43) Date of publication:
**24.01.2007 Bulletin 2007/04**

(51) Int Cl.:
***H05K 13/04*** *(2006.01)*

(21) Application number: **06122988.6**

(22) Date of filing: **12.05.2004**

(84) Designated Contracting States:
**DE GB**

(30) Priority: **13.05.2003 JP 2003134237**
**24.09.2003 JP 2003331310**

(62) Document number(s) of the earlier application(s) in accordance with Art. 76 EPC:
**04732484.3 / 1 625 780**

(71) Applicant: **MATSUSHITA ELECTRIC INDUSTRIAL CO., LTD.**
**Kadoma-shi, Osaka 571-8501 (JP)**

(72) Inventors:
• **Endo, Tadashi**
**Fukuoka 818-0041 (JP)**

• **Kido, Kazuo**
**Yamanashi 400-0053 (JP)**
• **Uchida, Hideki**
**Yamanashi 409-3866 (JP)**
• **Okuda, Osamu**
**Fukuoka 818-0024 (JP)**
• **Kakita, Nobuyuki**
**Yamanashi 400-0053 (JP)**

(74) Representative: **Eisenführ, Speiser & Partner**
**Patentanwälte Rechtsanwälte**
**Postfach 10 60 78**
**28060 Bremen (DE)**

Remarks:
This application was filed on 26 - 10 - 2006 as a divisional application to the application mentioned under INID code 62.

(54) **Electronic component feeder and electronic component feeding method**

(57) There are provided a forward-side regulating member (18) for regulating the support positions of the pallets loaded in a magazine (4) on the forward side in a pallet feed direction (A), a rearward-side regulating member (24) that is movable along the direction, for regulating the support positions of the pallets regulated by the forward-side regulating member on the rearward side in the direction, and a horizontal posture regulating member (26) that can be arranged between the pallets, for regulating the pallet support posture so as to maintain the roughly horizontal support posture of the pallets supported by one pair of the support sections by virtue of the arrangement.

*Fig. 5*

**Description**

Technical Field

The present invention relates to an electronic component feeder and an electronic component feeding method for feeding a plurality of electronic components arranged in alignment on a component feed tray to mount the components on a board.

Background Art

Conventionally, there have been known various structures of this kind of electronic component feeder. In such the electronic component feeder, a plurality of pallets, on which a component feed tray (hereinafter referred to as a tray) often used as a feeding system of electronic components to an electronic component mounting apparatus are placed, are loaded stacked in layers (or stacked in tiers) in a magazine. The electronic component feeder, which employs such the conventional magazine, is constructed so as to move up and down the magazine in the vertical direction, or the direction in which the pallets are stacked by means of an elevation unit, position one selected pallet in a pallet unloading position and unload the pallet out of the magazine by means of a pallet unloader. Normally, such a tray unloading is carried out by firstly collecting the pallet on which the used tray is placed by inserting the pallet into the magazine, next moving up or down the magazine by the elevation unit to place the selected one pallet in the unloading position, i.e., a position at the same height level as that of the pallet unloader and then drawing this selected pallet out of the magazine. Subsequently, by picking up (e.g., picking up by suction) each of the electronic components in the tray placed on the pallet unloaded from the magazine by means of the transfer head or the like of the electronic component mounting apparatus.

Moreover, when the electronic components in the tray have been picked up and depleted or in a similar case, the pallet, on which the emptied tray is placed, is replaced by a pallet on which a new tray is placed. However, the above-mentioned pallet replacing work is carried out by the operator's hand, when the operator sometimes sets (loads) the pallet reversely in the lengthwise direction by mistake into the magazine. Since the pallet does not generally have a structure symmetrical in the lengthwise direction, the reversely set pallet cannot produce its function, and this leads to a problem that the electronic component feeder cannot be correctly operated, possibly causing damages of the constituent components of the feeder as well as scattering and damages of the electronic components and so on arranged on the tray.

There has conventionally been developed an electronic component feeder, which can prevent the stop of the electronic component feeder and damages of the constituent components of the feeder due to erroneous setting in the lengthwise direction of the pallet into the magazine.

For example, there is a conventional electronic component feeder, in which the configurations of the edge portion located on the forward side and the edge portion located on the rearward side of each pallet are made different from each other and an engagement member having a configuration that engages with the forward-side edge portion and does not engage with the rearward-side edge portion is arranged on the forward side of the magazine (refer to, for example, Japanese unexamined Patent Publication 11-121985 A). According to the construction of such the conventional electronic component feeder, the erroneous setting of loading the pallet reversely in the lengthwise direction in the magazine can be prevented by the engagement member.

However, the aforementioned structure has a problem that, although the pallet can be prevented from being loaded reversely in the lengthwise direction, when the pallet is loaded correctly in the lengthwise direction even if the pallet is loaded inclined in the magazine, such the erroneous setting cannot be detected (or prevented).

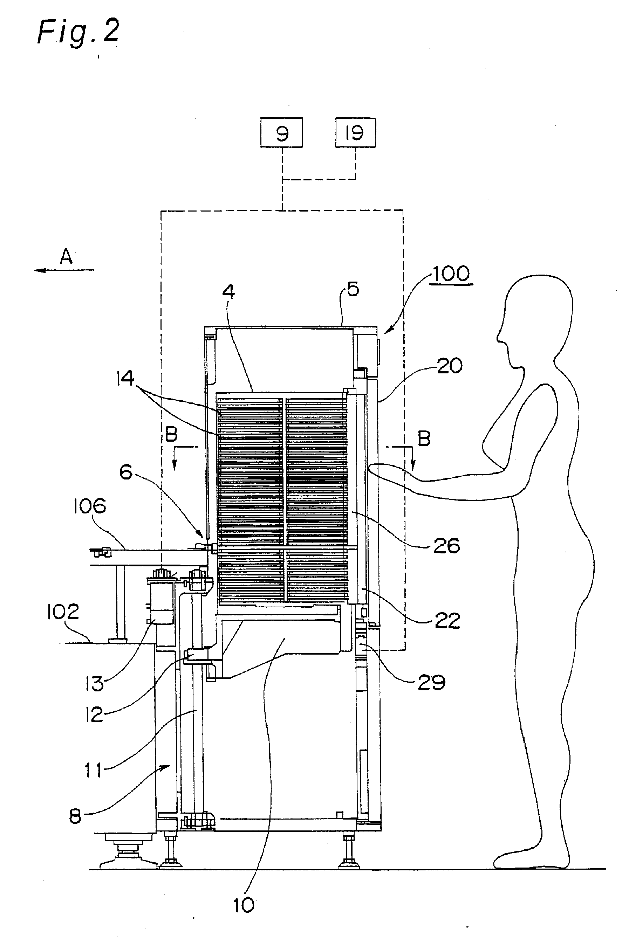

Particularly, with an increasing degree of unfamiliarity with work due to the shifting of the operators themselves and an increasing frequency of the replacement of the pallets in the magazine by the operators as a consequence of an increasing electronic component mounting speed and ongoing diversified small-lot production, there is an increasing number of cases of the erroneous reverse setting in the lengthwise direction and the erroneous inclined setting. Particularly, it is required to insert the pallet (or the magazine itself) while confirming the state of the electronic components, and therefore, the operator naturally turns his or her gaze downward upon the pallet from above (e.g., a positional relation between the operator and the pallet is shown in Fig. 2). In such a situation, the operator, who is concentrating his or her attention on the electronic components, is hardly aware of inclined pallet insertion. Moreover, there is a problem that the possibility of the occurrence of erroneous inclined pallet setting by the operators has been increased because of an increasing number of trays to be loaded in the magazine, i.e., an increasing number of the pallets in accordance with the reductions in size and thickness of the electronic components to be mounted and further with the diversification of the types of the electronic components.

Moreover, in the actual circumferences of the recent growing demands for high-speed and high-efficiency mounting of the electronic components, the operation stop of the electronic component feeder due to the erroneous pallet setting is one of the factors of hindering the achievement of the high speed and high efficiency. Also, for the achievement of the high-speed and high-efficiency mounting of the electronic components, it is demanded to make detectable any erroneous pallet setting in the magazine.

Moreover, there are known various methods for carrying out the suction and pickup (i.e., the aforementioned pickup) of each electronic component by sucking and holding each electronic component by means of a suction nozzle provided for the transfer head, the mounting head or the like from a tray fed by such the conventional electronic component feeder (refer to, for example, Japanese unexamined Patent Publication 10-335889 A), and its one example will be described with reference to the drawings.

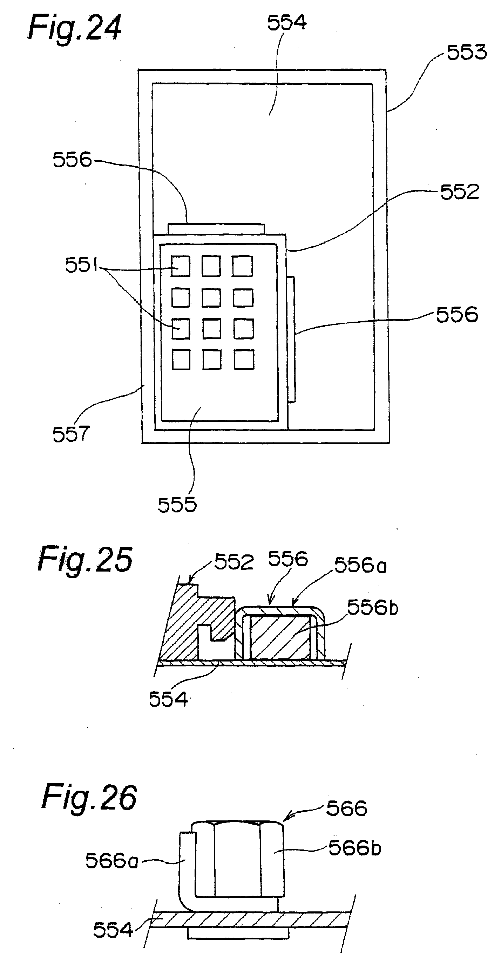

First of all, Fig. 24 shows a schematic plan view of a component feed tray 552 of one example of the tray in which electronic components 551 of such the plurality of electronic components are arranged in alignment for explanation. As shown in Fig. 24, the component feed tray 552, which has a roughly plate-like configuration, is arranged on a tray placement surface 554 that is the upper surface of a tray plate 553 (corresponding to the pallet) that similarly has a roughly plate-like configuration.

Moreover, the component feed tray 552 has a component arrangement region 555 on its upper surface, and the electronic components 551 are arranged in alignment in this component arrangement region 555. Moreover, the component feed tray 552 is arranged at, for example, the lower left-hand corner of the tray placement surface 554 in the drawing and arranged on the tray placement surface 554 with two fixation bars 556 brought in contact with the respective edge portions of the component feed tray 552. With this arrangement, the arrangement of the component feed tray 552 is fixed in directions along the surface of the tray placement surface 554.

In this case, Fig. 25 shows a schematic sectional view showing the cross-sectional structure of this fixation bar 556. As shown in Fig. 25, the fixation bar 556 is a rod-shaped member, which has a roughly C-figured cross section and includes a fixation bar main body 556a that fixes the arrangement position of the component feed tray 552 by being brought in contact with an end portion of the component feed tray 552 and a magnet section 556b fixed inside the C-figured cross section of this fixation bar main body 556a. Moreover, the fixation bar main body 556a can be magnetically releasably connected to the tray placement surface 554 of the tray plate 553 via this magnet section 556b.

Moreover, the end portion of the fixation bar main body 556a brought in contact with the end portion of the component feed tray 552 has an end surface configuration formed roughly perpendicular to the tray placement surface 554. Therefore, as shown in Fig. 25, the fixation bar 556 magnetically fixed on the tray placement surface 554 via the magnet section 556b comes in contact with the end portion of the component feed tray 552, by which the arrangement position of the component feed tray 552 can be fixed in a direction that extends along the surface of the tray placement surface 554 and roughly perpendicular to the direction in which the fixation bar 556 extends.

Moreover, as shown in Fig. 24, by using two fixation bars 556 described the above, the arrangement position of the component feed tray 552 can be fixed in mutually perpendicular two directions in the directions along the surface of the tray placement surface 554. As shown in Fig. 24, peripheral portions 557 of the tray plate 553 are formed protuberant above the tray placement surface 554, and the other two sides in which the two fixation bars 556 are not in contact at the component feed tray 552 are brought in contact with the peripheral portions 557 of the tray plate 553. With this arrangement, the arrangement position is fixed in the aforementioned directions in with the four sides of the component feed tray 552 are surrounded by the peripheral portions 557 of the tray plate 553 and the two fixation bars 556.

Moreover, the conventional fixation bar 556 described the above is not limited to the one that is provided with the magnet section 556b and magnetically fixed on the tray placement surface 554, and fixation bars 556 of various forms are used. For example, as shown in Fig. 26, there is also used a conventional fixation bar 566 having a form such that a rod-shaped fixation bar main body 566a having a roughly L-figured cross-sectional shape is fixed on the tray placement surface 554 by a fastening screw 566b. Even in the case of the fixation bar 566 described the above, the end surface configuration of the end portion to be brought in contact with the end portion of the component feed tray 552 is formed roughly perpendicular to the tray placement surface 554.

However, in the above-mentioned structure, although the arrangement position of the component feed tray 552 is fixed on the tray placement surface 554 of the tray plate 553, the fixation is only effected in the directions along the surface of the tray placement surface 554. Therefore, in the case where a suction nozzle disadvantageously sucks and holds, for example, the portion where the electronic component 551 is not arranged on the component feed tray 552, when the electronic components 551 arranged on the component feed tray 552 are each sucked and held and picked up by the suction nozzle, there is a problem that the component feed tray 552 itself is disadvantageously uplifted from the tray placement surface 554 in accordance with the ascent of the suction nozzle, possibly causing displacements in the arrangement positions of the other electronic components 551 arranged on the component feed tray 552 and leap-up of the electronic components 551 from the component feed tray 552.

The occurrence of such a problem becomes significant particularly when electronic components 551 that tend to be reduced in thickness in recent years are picked up by suction and holding. That is, a difference in the height position between the height position of the suction and holding surface of the electronic component 551 reduced in thickness by the suction nozzle and the height position of the arrangement surface of the electronic component 551 on the component feed tray 552 is reduced in accordance with the reduction in the thickness of the electronic component 551. Accordingly, there are the problems of high possibility of the occurrence of the disadvantageous suction of the component feed tray 552 by the suction force of the suction nozzle when there is no electronic component 551 existing in the height position where the electronic component 551 is sucked and held by the lowered suction nozzle and high possibility of the consequent occurrence of the uplift of the component feed tray 552 and so on.

Moreover, the occurrence of erroneous suction of the component feed tray 552 by the suction nozzle as described above is sometimes caused by erroneous input of component data or the like of the electronic components 551 to a control unit that executes motion control of the suction nozzle.

As described above, there is a problem that efficient electronic component feeding cannot be achieved when the leap-up or the like of electronic components 551 is caused by the erroneous suction of the component feed tray by the suction nozzle, and this significantly lower the rate of operation of the electronic component mounting apparatus provided with the suction nozzle, failing in carrying out efficient component mounting.

Disclosure Of Invention

Accordingly, the object of the present invention is to solve the aforementioned problems and provide an electronic component feeder and electronic component feeding method capable of carrying out efficient electronic component feeding by achieving smooth and reliable feeding operation in electronic component feeding for feeding a plurality of electronic components arranged in alignment on a component feed tray for the mounting of the components on a board.

In concrete, by reliably easily detecting the presence or absence of abnormality in the pallet support posture in the magazine and preventing the stop of the electronic component feeder operation and the damage of the constituent components of the feeder attributed to the abnormality in the support posture in the electronic component feeder that feeds the plurality of electronic components arranged in alignment on the component feed tray to an electronic component mounting apparatus, the electronic component feeder capable of achieving the efficient feeding of the electronic components is provided.

Furthermore, there is provided an electronic component feeder and electronic component feeding method capable of achieving the aforementioned efficient feeding of the electronic components by preventing the leap-up of the components caused by the erroneous suction of the component feed tray by the component suction and holding member beforehand at the time of the component pickup carried out by sucking and holding the components from the component feed tray arranged allowing the plurality of electronic components to be picked up by the component suction and holding member.

In accomplishing these and other aspect, according to a 1st aspect of the present invention, there is provided an electronic component feeder for loading a plurality of pallets on each of which a component feed tray for carrying a plurality of electronic components arranged in alignment are placed in a plurality of stacked tiers, for feeding the electronic components on the component feed tray placed on a pallet unloaded from among the loaded pallets to an electronic component feed position along a pallet feed direction, the feeder comprising:

a magazine, in which a plurality of pairs of support sections for supporting mutually opposed edge portions of the pallets in a direction perpendicular to the pallet feed direction so that the pallets are supported roughly horizontally and movably in the pallet feed direction are formed at regular intervals in a stacking direction, for loading the pallets supported by the corresponding pairs of support sections;
a magazine receiver for receiving the magazine elevatably, which has a pallet feed port for allowing the pallets loaded in the magazine to be unloaded from inside the magazine to an electronic component feed position;
a magazine elevation unit for driving elevation of the magazine inside the magazine receiver while allowing a selected pallet to be unloaded through the pallet feed port;
a forward-side regulating member for regulating support positions of the pallets loaded in the magazine by the corresponding support sections by being brought in contact with an edge portion of the pallet on a forward side in the pallet feed direction;
a rearward-side regulating member, movable in the pallet feed direction, for regulating support positions of the pallets regulated by the forward-side regulating member by the corresponding support sections by being brought in contact with an edge portion of the pallet on a rearward side in the pallet feed direction; and
a horizontal posture regulating member, which is provided integrally with the magazine, for regulating the roughly horizontal support posture of the pallets so that the support posture of each of the pallets, whose edge portions are supported by the corresponding pairs of support sections, by being arranged between the pallets stacked in tiers in the magazine,
the pallets being formed so that configurations of a forward-side edge portion and a rearward-side edge portion in the pallet feed direction are formed differently, the feeder being able to detect inclusion of the pallet supported in a reversely directed support posture in the pallet feed direction in the magazine on the basis of the regulation position of the pallet by the rearward-side regulating member, and the feeder being able to detect inclusion of the pallet in a support posture supported by support sections that are not mutually opposed in the magazine by means of the horizontal position regulating member.

According to a 2nd aspect of the present invention, there is provided the electronic component feeder as claimed in the 1st aspect, wherein
the magazine is provided with a magazine door section which is an openable door provided on the rearward side in the pallet feed direction for feeding and loading the pallets from the rearward side and on the inside of which the rearward-side regulating member and the horizontal posture regulating member are fixed,
wherein the rearward-side regulating member can limit closing of the magazine door section by bringing in contact with the edge portion of the pallet supported in the reversely directed support posture, the magazine door section can be closed in a position where the rearward-side regulating member is brought in contact with the edge portion of the pallet supported in a forwardly directed support posture in the pallet feed direction,
the horizontal posture regulating member can limit closing of the magazine door section by bringing in contact with the edge portion of the pallet supported by the support sections that are not mutually opposed, the magazine door section can be closed by inserting the horizontal posture regulating member between the pallets supported by the pair of support sections, and
inclusion of the pallet that has abnormality in its support posture in the magazine can be detected by the limitation of the closing of the magazine door section.

According to a 3rd aspect of the present invention, there is provided the electronic component feeder as claimed in the 2nd aspect, further comprising:

a door opening/closing detector for detecting the open state or the closed state of the magazine door section; and
a door opening and closing display section for displaying a detection result by the door opening/closing detector while allowing an operator to recognize the result.

According to a 4th aspect of the present invention, there is provided the electronic component feeder as claimed in the 3rd aspect, wherein
the magazine receiver has a receiver door section that is an openable door provided on the rearward side in the pallet feed direction, for being closed in a state in which its inside is brought in contact with outside of the magazine door section in the closed state, for being limited its closing by bringing in contact with the outside of the magazine door section to limit the closing.

According to a 5th aspect of the present invention, there is provided the electronic component feeder as claimed in the 4th aspect, wherein the door opening/closing detector is provided for the receiver door section.

According to a 6th aspect of the present invention, there is provided the electronic component feeder as claimed in the 3rd aspect, further comprising a control unit for stopping driving operation of the magazine elevation unit when the open state of the magazine door section is detected by the door opening/closing detector.

According to a 7th aspect of the present invention, there is provided the electronic component feeder as claimed in the 2nd aspect, wherein the horizontal posture regulating member is provided with a plurality of projections which are formed arranged in the stacking direction at the same intervals as the intervals of the support sections, for being inserted in gaps between the pallets supported by the pair of support sections, for being limited to insert in the gaps by bringing in contact with the edge portion of the pallets supported by the support sections that are not mutually opposed.

According to an 8th aspect of the present invention, there is provided the electronic component feeder as claimed in the 7th aspect, wherein the horizontal posture regulating member is fixed on the magazine door section so that the projections are arranged in positions located closer to either one of the support sections away from a possible intermediate between the mutually opposed support sections in a state in which the magazine door section is closed.

According to a 9th aspect of the present invention, there is provided the electronic component feeder as claimed in the 8th aspect, wherein the projections are arranged so that any of the projections interferes with the pallet supported by the support sections which include the other support section displaced by at least one step in the stacking direction with respect to the support section opposed to one support section.

According to a 10th aspect of the present invention, there is provided the electronic component feeder as claimed in the 1st aspect, wherein
each of the pallets has a pallet unloading grip portion, which has a roughly rectangular shape and is formed roughly in a protruding configuration at an edge portion located on the forward side in the pallet feed direction, and
the rearward-side regulating member is arranged so as to be able to come in contact with the grip portion of the pallet supported in the reversely directed support posture by the support sections.

According to an 11th aspect of the present invention, there is provided the electronic component feeder as claimed in the 7th aspect, wherein the projections of the horizontal posture regulating member have a length dimension such that the projections do not reach a place above an arrangement region of the electronic components on the component feed tray placed on each of the pallets in a state in which the projections are inserted in gaps between the pallets.

According to a 12th aspect of the present invention, there is provided the electronic component feeder as claimed in the 1st aspect, wherein

the feeder further comprises a component feed tray fixation bar for fixing the component feed tray releasably on a placement surface of the pallet, and

the fixation bar comprising:

a first direction fixation portion, for releasably fixing its arrangement position on the placement surface, for releasably fixing the placement position of the component feed tray in a first direction that is a direction along the placement surface by being brought in contact with the component feed tray placed on the placement surface; and

a second direction fixation portion, for releasably fixing its arrangement position on the placement surface, for releasably fixing the placement position in a second direction that is a direction roughly perpendicular to the placement surface by being brought in contact with the component feed tray.

According to a 13th aspect of the present invention, there is provided the electronic component feeder as claimed in the 12th aspect, wherein, with regard to the component feed tray fixation bar,

the first direction fixation portion is the first direction fixation surface formed roughly perpendicular to the placement position where the placement position is fixed in the first direction by being brought in contact with an end portion of the component feed tray, and

the second direction fixation portion is the second direction fixation surface formed roughly perpendicular to the placement position where the placement position is fixed in the second direction by being brought in contact with an end portion of the component feed tray.

According to a 14th aspect of the present invention, there is provided the electronic component feeder as claimed in the 13th aspect, wherein, with regard to the component feed tray fixation bar,

a height position of the second direction fixation surface brought in contact with the edge portion of the component feed tray is adjustable in the second direction.

According to a 15th aspect of the present invention, there is provided the electronic component feeder as claimed in the 12th aspect, wherein, with regard to the component feed tray fixation bar,

the fixation bar is provided with an urging member that always urges the second direction fixation portion toward the end portion of the component feed tray.

According to a 16th aspect of the present invention, there is provided the electronic component feeder as claimed in the 13th aspect, wherein, with regard to the component feed tray fixation bar,

the fixation bar comprising:

a plurality of the second direction fixation surfaces formed at different height levels; and

a plurality of the first direction fixation surfaces individually corresponding to the second direction fixation surfaces, and

the placement position of the component feed tray is fixed by the second direction fixation surface that conforms to the height of the end portion of the component feed tray and belongs to the second direction fixation surfaces and the first direction fixation surface that corresponds to the second direction fixation surface.

According to a 17th aspect of the present invention, there is provided the electronic component feeder as claimed in 12th aspect, wherein, with regard to the component feed tray fixation bar,

the first direction fixation portion is the first direction fixation surface for fixing the placement position in the first direction by being brought in contact with the end portion of the component feed tray,

the second direction fixation portion is the second direction fixation surface for fixing the placement position in the second direction by being brought in contact with the end portion of the component feed tray, and

the first direction fixation surface and the second direction fixation surface serve as an identical fixation surface formed inclined with respect to the placement surface.

According to an 18th aspect of the present invention, there is provided the electronic component feeder as claimed in the 12th aspect, wherein, with regard to the component feed tray fixation bar,

the fixation bar, comprises a magnetic member formed of a magnetic material on or near its arrangement surface on the placement surface, for being fixed on the placement surface by a magnetic force of the magnetic member.

According to a 19th aspect of the present invention, there is provided an electronic component feeding method for feeding a plurality of electronic components to be mounted on a board by carrying out suction and holding and pickup of the electronic components from a component feed tray in which the electronic components are arranged while being able to be sucked and picked up by a component suction and holding member capable of sucking and holding each of the components with its suction pressure,

the component suction and holding member carrying out the suction and holding and pickup of each of the electronic components with a component holding and suction pressure which is a suction pressure that is not lower than a suction pressure capable of sucking and holding the electronic component and lower than a suction pressure capable of sucking and holding the component feed tray.

According to a 20th aspect of the present invention, there is provided the electronic component feeding method as claimed in the 19th aspect, wherein:

bringing the component suction and holding member in contact with the electronic component by lowering the component suction and holding member after aligning in position the component feed tray with the component suction and holding member;

starting suction by the component suction and holding member so that the suction pressure reaches the component holding and suction pressure when the component suction and holding member brought in contact with the electronic component starts ascending; and

carrying out the suction and holding and pickup of the electronic component with the ascent of the component suction and holding member.

According to a 21st aspect of the present invention, there is provided the electronic component feeding method as claimed in the 20th aspect, wherein a timing of starting the suction is determined in consideration of a time for which the suction pressure reaches the component holding and suction pressure from the start of the suction by the component suction and holding member.

According to a 22nd aspect of the present invention, there is provided the electronic component feeding method as claimed in the 20th aspect, wherein starting the suction by the component suction and holding member after the component suction and holding member is brought in contact with the electronic component.

According to a 23rd aspect of the present invention, there is provided the electronic component feeding method as claimed in the 20th aspect, wherein the time for lowering the component suction and holding member is determined according to a size or a weight of the electronic component so as to prevent leap-up of the electronic component from the component feed tray due to the component suction and holding member brought in contact with the electronic component.

According to a 24th aspect of the present invention, there is provided the electronic component feeding method as claimed in any one of the 19th aspect through the 23rd aspect, wherein the component holding and suction pressure is a suction pressure determined according to a size or a weight of the electronic component.

According to the first aspect of the present invention, the electronic component feeder is provided with the forward-side regulating member that regulates the support position of the pallets loaded in the magazine by the respective support sections by being brought in contact with the edge portions of the pallets on the forward side in the pallet feed direction and the rearward-side regulating member that is movable along the pallet feed direction and regulates the pallets regulated by the forward-side regulating member by being brought in contact with the edge portions of the pallets on the rearward side in the pallet feed direction. With this arrangement, when the pallets, which are formed so that the edge configuration on the forward side and the edge configuration on the rearward side are different from each other, are loaded in the magazine, it can be detected that the pallet loaded in the reversely directed support posture is included among the loaded pallets on the basis of a difference in the contact position by the rearward-side regulating member.

Furthermore, with the provision of the horizontal posture regulation member, which can be arranged between the pallets loaded in the magazine and regulates the roughly horizontal pallet support posture so as to maintain the support posture by virtue of the above-mentioned arrangement, by arranging the horizontal posture regulation member in the gaps between the pallets, the pallets can be loaded in the magazine without being inclined with the roughly horizontal support posture maintained. Furthermore, when the horizontal posture regulation member cannot be arranged in the gaps due to the contact and consequent interference of the horizontal posture regulation member with any of the pallets, it can be detected that there is included a pallet in the inclined support posture.

Therefore, the abnormality in the support posture of the pallet loaded in the magazine can be detected reliably and easily in the electronic component feeder, and the pallets can consistently be loaded in the correct support posture. Therefore, the occurrence of the operation stop of the electronic component mounting apparatus and damages or the like of the constituent components of the electronic component feeder attributed to the aforementioned pallet support posture can be prevented.

According to the second aspect of the present invention, the magazine door section is provided with the rearward-side regulating member and the horizontal posture regulating member, and the closing of the magazine door section is limited in the aforementioned position where the rearward-side regulating member is brought in contact with the edge portion of the pallet supported in the reversely directed support posture. Moreover, by the limitation of the closing of the magazine door section due to the horizontal posture regulating member brought in contact with the edge portion of the pallet supported by the support sections that are not mutually opposed, it can reliably be detected that the pallet having abnormality in its support posture is included among the pallets loaded in the magazine. Moreover, since the above-mentioned detection can be carried out only by opening or closing the magazine door section, it is possible to carry out the detection more easily and recognizably to the operator.

According to the third aspect of the present invention, it is possible to reliably detect the opening/closing of the magazine door section and reliably make the operator recognize the result by the door opening/closing detection section capable of detecting the open state or the closed state of the magazine door section and the door opening/closing display section that displays the detection result by the door opening/closing detection section recognizably to the operator.

According to another aspect of the present invention, it is possible to regard the opening/closing of the receiver door section, which is opened and closed in accordance with the opening and closing of the magazine door section, as the opening/closing of the magazine door section and to provide the receiver door section with the door opening/closing detection section.

Moreover, by stopping the driving by the magazine elevation unit when the open state of the magazine door section is detected by the door opening/closing detection section, the occurrence of damages or the like of the constituent components of the feeder attributed to the abnormality in the pallet support posture can be prevented beforehand.

Moreover, the horizontal posture regulating member is provided with the plurality of projections to be inserted in the gaps between the pallets. With this arrangement, any projection among the projections interferes with any of the pallets, making it possible to reliably easily detect that the pallet in the inclined support posture is loaded in the magazine.

Moreover, the projections of the horizontal posture regulating member are arranged avoiding the position intermediate between the mutually opposed support sections. With this arrangement, the pallet in the inclined support posture and any of the projections can reliably be made to interfere with each other, allowing the abnormality in the pallet support posture can reliably be detected.

Moreover, the projections are arranged so that any of the projections interferes with the pallet supported by the support sections of which the other support section is displaced by at least one step in the stacking direction with respect to the support section opposed to one support section. With this arrangement, the support posture displaced by one step, which tends to be rather neglected by the operator, can reliably be detected.

Moreover, the pallets having a roughly rectangular shape have a grip portion, which is to unload the pallet and is formed roughly in a protruding configuration at an edge portion located on the forward side in the pallet feed direction, are employed in the magazine, and the rearward-side regulating member is arranged so as to be able to come in contact with the grip portion of the pallet supported in the reversely directed support posture by the support sections. With this arrangement, the forwardly directed support posture and the reversely directed support posture of the pallet can reliably be distinguished and detected by a difference in the position where the pallet is brought in contact with the rearward-side regulating member.

Moreover, the projections of the horizontal posture regulating member are formed with a dimension in length such that the projections do not reach a place above the region where the electronic components are arranged on the tray placed on each of the pallets in the state in which the projections are inserted in the gaps between the pallets. This arrangement is able to reliably prevent interference between the electronic components arranged in alignment in the arrangement region and the projections and reliably prevent the occurrence of damages of the electronic components.

According to the twelfth aspect of the present invention, the component feed tray fixation bar, which releasably fixes the component feed tray on the pallet placement surface in the electronic component feeder, is provided with not only the first direction fixation portion that fixes the placement position of the component feed tray in the first direction, or the direction along the placement surface but also the second direction fixation portion that fixes the placement position of the component feed tray in the second direction roughly perpendicular to the placement surface. With this arrangement, the component feed tray can be fixed in the first direction and the second direction.

If, for example, the case where the component feed tray itself is sucked and held (so-called the erroneous suction) by the component suction and holding member in sucking and holding the component arranged on the thus fixed component feed tray by means of the component suction and holding member occurs, the component feed tray is fixed also in the second direction, and therefore, the occurrence of the uplift of the component feed tray can be prevented beforehand. Accordingly, there can be provided a component feed tray fixation bar capable of preventing the occurrence of the leap-up, displacement in the arrangement position and so on of the components due to the occurrence of the erroneous suction of the component feed tray during the component mounting and contributing to the achievement of efficient component feeding.

Moreover, according to another aspect of the present invention, the first direction fixation portion is the surface (first direction fixation surface) arranged roughly perpendicular to the placement surface, and the second direction fixation portion is the surface (second direction fixation surface) arranged along the placement surface. With this arrangement, by bringing the surfaces in contact (e.g., contact causing surface contact) with the end portions of the component feed tray, the component feed tray can be fixed in the first direction and the second direction.

Moreover, the height position of contact with the end portion of the component feed tray on the second direction fixation surface is adjustable in the second direction. This arrangement can cope with the fixation of component feed trays that have a variety of configurations and allows the fixation to be reliably achieved.

Moreover, the fixation bar is provided with an urging member that consistently urges the second direction fixation portion toward the end portion of the component feed tray along the second direction. With this arrangement, the force of fixation in the second direction can be further improved, allowing more reliable fixation to be achieved. Furthermore, the increased force of fixation can reliably resist the force that tries to uplift the component feed tray due to the erroneous suction of the component feed tray by the component suction and holding member.

Moreover, with the plurality of first direction fixation surfaces and second direction fixation surfaces formed individually in correspondence, the component feed tray can be fixed by selecting the combination of the fixation surfaces corresponding to the configuration (e.g., an end portion formation height and so on) of the component feed tray to be fixed. This arrangement can therefore cope with the fixation of component feed trays that have further diversified configurations.

Moreover, the first direction fixation surface and the second direction fixation surface are the identical fixation surface formed inclined with respect to the placement surface. With this arrangement, the component feed tray can concurrently be fixed in the first direction and the second direction by the identical fixation surface. Therefore, the configuration of the fixation bar can be simplified, and the production workability can be made satisfactory. Furthermore, the fixation is effected by bringing the inclined fixation surface in contact with the end portion of the component feed tray. Therefore, it becomes possible to achieve the above-mentioned contact without being influenced by the formation height of the end portion, and this can cope with the fixation of component feed trays that have diversified forms.

Moreover, since the fixation bar is provided with the magnetic member, the fixation bar can be fixed in the desired position of the placement surface by the magnetic force of the magnetic member. This allows the handlability of the fixation bar to be satisfactory and reliable fixation to be achieved regardless of the configuration of the component feed tray to be fixed.

According to the nineteenth aspect of the present invention, by the electronic component feeding method for feeding electronic components from the component feed tray to a board by means of the component suction and holding member, even when the erroneous suction of the component feed tray by the component suction and holding member occurs by carrying out the suction and holding and pickup of the electronic component with a component holding and suction pressure of a suction pressure that is not lower than the suction pressure capable of sucking and holding the electronic component and lower than the suction pressure capable of sucking and holding the component feed tray, the erroneously sucked component feed tray is not uplifted with the lifting of the component suction and holding member, and the occurrence of leap-up of the electronic components and so on caused by the occurrence of the uplift can be prevented beforehand. Therefore, an electronic component feeding method capable of carrying out reliable component pickup and contributing to the achievement of efficient component mounting can be provided.

Moreover, according to another aspect of the present invention, by starting the suction by the component suction and holding member so that the suction pressure reaches the component holding and suction pressure when the lifting of the component suction and holding member brought in contact with the electronic component is started, the suction can be started with reference to the time point of operation at which the component suction and holding suction pressure is needed, and the time zone in which a needless suction pressure is generated can be shortened. As a result, the possibility of the occurrence of some influences (e.g., the occurrence of displacement caused by the suction of the neighboring components and the occurrence of the erroneous suction of the component feed tray itself) on the peripheries of the component suction and holding member due to the generation of the suction pressure can be reduced. Moreover, it is possible to promote energy saving by a reduction in the suction pressure application time.

Moreover, the suction start timing is determined in consideration of the time needed from the start of suction by the component suction and holding member to the time when the suction pressure reaches the component holding and suction pressure. This makes it possible to reliably generate the component holding and suction pressure at the time of starting the lifting of the component suction and holding member and to carry out reliable suction and holding.

Moreover, the suction start by the component suction and holding member is carried out after the component suction and holding member is brought in contact with the component. This makes it possible to reliably suck and hold only the electronic component brought in contact by the generated suction pressure and to reliably prevent the occurrence of the erroneous suction of the component feed tray.

Moreover, the time needed for lowering the component suction and holding member is determined in accordance with the size or weight of the component so as to prevent the leap-up of the electronic component from the component feed tray due to the component suction and holding member brought in contact with the electronic component, and the component holding and suction pressure is a suction pressure determined in accordance with the size or weight of the component. This arrangement can cope with the suction and holding of a variety of types of electronic components.

Brief Description of Drawings

These and other aspects and features of the present invention will become clear from the following description taken in conjunction with the preferred embodiments thereof with reference to the accompanying drawings, in which:

Fig. 1 is an external perspective view of an electronic component mounting apparatus provided with an electronic component feeder according to a first embodiment of the present invention;

Fig. 2 is a schematic cross-sectional view showing a schematic structure of the electronic component feeder of Fig. 1;

Fig. 3 is a schematic perspective view of a tray and a pallet handled by the electronic component feeder;

Fig. 4 is a schematic sectional view (showing the normal loading state of the pallets) of a cross section perpendicular to a pallet feed direction of a magazine;

Fig. 5 is a cross-sectional view taken along the line B-B (showing the normal loading state of the pallets) of the electronic component feeder of Fig. 2;

Fig. 6 is a sectional view showing a state in which an outer door and an inner door are opened at the electronic component feeder of Fig. 5;

Figs. 7A and 7B are schematic sectional views of a large-size magazine in a direction perpendicular to the pallet feed direction, showing a state in which a pallet in an inclined support posture is included, where Fig. 7A shows a state in which the pallet is supported by rack portions shifted by two steps, and Fig. 7B shows a state in which the pallet is supported by rack portions shifted by one step;

Figs. 8A and 8B are schematic sectional views of a small-size magazine in a direction perpendicular to the pallet feed direction, showing a state in which the pallet in an inclined support posture is included, where Fig. 8A shows a state in which the pallet is supported by rack portions shifted by two steps, and Fig. 8B shows a state in which the pallet is supported by rack portions shifted by one step;

Fig. 9 is a view corresponding to the sectional view of the electronic component feeder of Fig. 4, showing a state in which the pallet is loaded in a reversely directed support posture;

Fig. 10 is a view corresponding to the sectional view of the electronic component feeder of Fig. 4, showing a state in which the pallet is loaded in an inclined support posture;

Fig. 11 is a schematic partial sectional view of a cross section of the small-size magazine in the direction perpendicular to the pallet feed direction;

Fig. 12 is a schematic partial sectional view of a cross section of the large-size magazine in the direction perpendicular to the pallet feed direction;

Figs. 13A and 13B are schematic views of a tray plate provided with fixation bars used in an electronic component feeder according to a second embodiment of the present invention, where Fig. 13A shows a plan view, and Fig. 13B shows a side view;

Figs. 14A and 14B are schematic views of a state in which a component feed tray is fixed on the tray plate of Figs. 13A and 13B by means of fixation bars, where Fig. 14A shows a plan view, and Fig. 14B shows a side view;

Fig. 15 is a schematic sectional view of the fixation bar of Figs. 13A and 13B;

Fig. 16 is a schematic explanatory view showing a force generated when an attractive force is imposed on the component feed tray fixed by the fixation bar of Figs. 13A and 13B;

Fig. 17 is a sectional view of a fixation bar according to a first modification example of the fixation bar of Fig. 15;

Fig. 18 is a sectional view of a fixation bar according to a second modification example of the fixation bar of Fig. 15;

Fig. 19 is a sectional view of a fixation bar according to a third modification example of the fixation bar of Fig. 15;

Figs. 20A and 20B are schematic views of a tray plate according to the modification example of the tray plate of Figs. 13A and 13B, where Fig. 20A shows a plan view, and Fig. 20B shows a side view;

Figs. 21A, 21B and 21C are operation timing charts of an electronic component feeding method according to a third embodiment of the present invention, where Fig. 21A shows suction valve operation timing, Fig. 21B shows a state of a suction pressure change, and Fig. 21C shows an elevation height position of the suction nozzle;

Fig. 22 is a schematic side view of a component mounting head of the third embodiment;

Figs. 23A, 23B and 23C are schematic views showing the suction nozzle operation of the electronic component feeding method of Figs. 21A, 21B and 21C, where Fig. 23A shows a state in which the suction nozzle is descending, Fig. 23B shows a state in which the suction nozzle is brought in contact with an electronic component, and Fig. 23C shows a state in which the electronic component is sucked and held and picked up;

Fig. 24 is a schematic plan view of a conventional tray plate;

Fig. 25 is a schematic sectional view of a conventional fixation bar;

Fig. 26 is a schematic sectional view of a fixation bar according to another conventional example; and

Fig. 27 is a sectional view of a fixation bar according to a modification example of the fixation bar of Fig. 15.

Best Mode for Carrying Out the Invention

Before the description of the present invention proceeds, it is to be noted that like components are designated by like reference numerals throughout the accompanying drawings.

(First Embodiment)

The first embodiment of the present invention will be described in detail below with reference to the drawings.

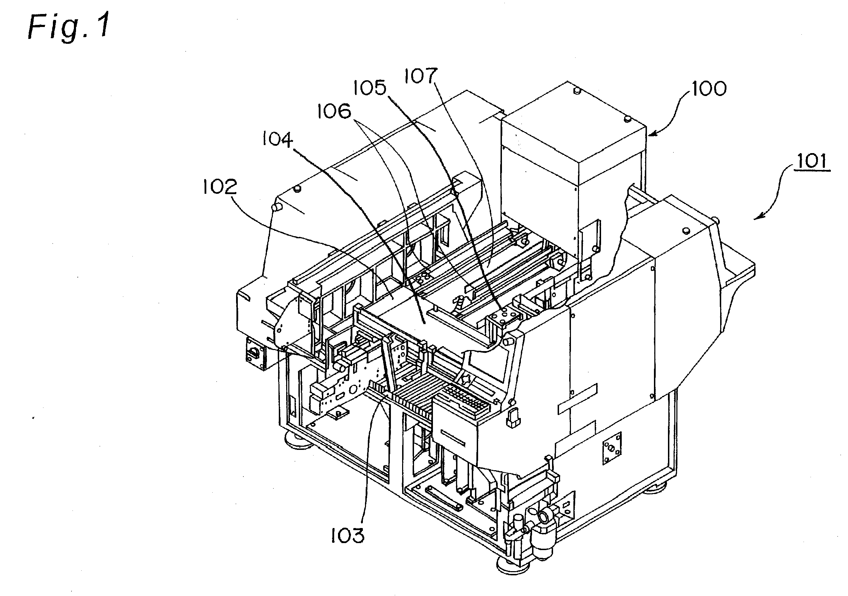

Fig. 1 shows an external perspective view (illustrated partially transparently) of an electronic component mounting apparatus 101 provided with an electronic component feeder 100 according to the first embodiment of the present invention.

As shown in Fig. 1, the electronic component mounting apparatus 101, which carries out component mounting for mounting a plurality of fed electronic components onto a circuit board, is provided with the electronic component feeder 100 (this may be referred to as a tray component feeder) that feedably accommodates a plurality of electronic components arranged in alignment on a tray removably on the illustrated rearward side of a machine base 102 of the electronic component mounting apparatus 101 and provided with a tape-carried component feeder 103, which feeds a plurality of tape-carried electronic components accommodated arranged in alignment in a line and is located on the illustrated frontward side of the machine base 102. The tape-carried component feeder 103 mainly feeds electronic components of small-size chip components and so on, while the electronic component feeder 101 feeds electronic components of a size comparatively larger than the chip components and electronic components that have specific shapes, such as IC components of, for example, QFP (Quad Flat Package) and BGA (Ball Grid Array) and so on.

As shown in Fig. 1, the electronic component mounting apparatus 101 has a stage 104, that is arranged in a roughly center portion of the machine base 102, for fixing a circuit board fed to the electronic component mounting apparatus 101 releasably and a head section 105 for mounting each of electronic components fed from the electronic component feeder 100 or the tape-carried component feeder 103 onto the circuit board fixed on the stage 104. An unloader 106 for unloading the tray, which is removably loaded in the electronic component feeder 100, for bringing each of the electronic components arranged on the unloaded tray into a state in which each of the components can be picked up by the head section 105 is provided on the machine stand 102 located between the electronic component feeder 100 and the stage 104. It is to be noted that the position in which the tray unloaded by this unloader 106 is arranged is an electronic component feed position 107.

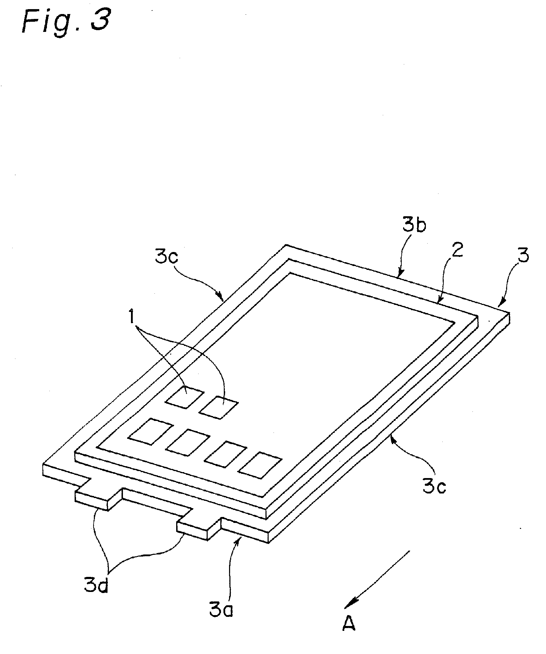

Next, a longitudinal sectional view showing the schematic structure of the electronic component feeder 100 is shown in Fig. 2. Fig. 3 shows a schematic perspective view of the tray loaded in the electronic component feeder 100.

As shown in Fig. 3, a plurality of electronic components 1 are arranged in alignment on the upper surface of a tray 2 that has a roughly quadrangular plate-like shape. The tray 2 is placed on the upper surface of a pallet 3 that has a roughly quadrangular plate-like shape. A plurality of pallets 3 on each of which the tray 2 is thus placed are loaded in a stack vertically at regular intervals in the electronic component feeder 100.

As shown in Fig. 2, the electronic component feeder 100 has a magazine 4 that is a box to be loaded with a plurality of pallets 3 in a stack as described above and a main body section 5 that is a box-shaped casing that receives this magazine 4 elevatably along the inside thereof and serves as one example of the magazine receiver.

Moreover, as shown in Fig. 2, the main body section 5 of the electronic component feeder 100 is arranged adjacently to the machine base 102 of the electronic component mounting apparatus 101. A pallet feed port 6, which is an opening to unload the pallet 3 by the unloader 106 arranged on the machine base 102, is provided on the left-hand side in the figure, and the pallet 3 can be unloaded from inside the magazine 4 through this pallet feed port 6 by the unloader 106. In Fig. 2, the leftward direction in the figure is the unloading direction of each pallet 3 by the unloader 106, i.e., a pallet feed direction A.

Moreover, as shown in Fig. 2, the electronic component feeder 100 has a magazine elevation unit 8 for moving up and down the magazine 4 inside the main body section 5. The magazine elevation unit 8 has a magazine support base 10 for supporting the magazine 4 in its lower portion, a ball screw shaft section 11 that is arranged in the vertical direction in the figure and is fixed to the main body section 5 rotatably around the axis thereof, a nut section 12 that is meshed with this ball screw shaft section 11 and fixed to the magazine support base 10 and an elevation drive motor 13 for driving the rotation of the ball screw shaft section 11 around the axis selectively in either the forward or reverse rotational direction. By rotating the elevation drive motor 13 in either the forward or reverse rotational direction, the nut section 12 can be moved up or down along the ball screw shaft section 11, by which the magazine 4 supported on the magazine support base 10 can be moved up and down along the inside of the main body section 5. When selected one pallet 3 is unloaded from among the pallets 3 loaded in the magazine 4, by moving up and down the magazine 4 by the magazine elevation unit 8 so that the selected pallet 3 is located in the height position of the pallet feed port 6, the pallet 3 located in the height position can be unloaded through the pallet feed port 6 by the unloader 106.

Moreover, as shown in Fig. 2, a plurality of rack sections 14, which is one example of the support section that has a recessed cross-sectional configuration, are formed with a constant spacing pitch in the vertical direction on the mutually opposed inner side surfaces of the magazine 4 in a direction perpendicular to the pallet feed direction A (i.e., direction perpendicular to the sheet plane of Fig. 2). The rack sections 14 are formed in a groove-like form so as to extend along the pallet feed direction A on the inner side surfaces of the magazine 4 and able to support the edge portions of the pallet 3 on the mutually opposed rack sections 14, i.e., a pair of rack sections 14 and to move the pallet 3 in the supported state in a direction in which the rack sections 14 are formed, i.e., along the pallet feed direction A.

Here is described more in detail the structure of the pallet 3 referring back to Fig. 3. As shown in Fig. 3, the edge portions in the direction perpendicular to the pallet feed direction A out of the four edge portions of the pallet 3 serve as support side edge portions 3c movably supported by a pair of rack sections 14 of the magazine 4 as described above. The edge portion of the pallet 3 located on the forward side (on this side in the figure) in the pallet feed direction A serves as a forward side edge portion 3a, and protruding grip portions 3d to grip the pallet 3 by the unloader 106 are formed at the forward side edge portion 3a. The edge portion of the pallet 3 located on the rearward side (far side in the figure) in the pallet feed direction A serves as a rearward side edge portion 3b.

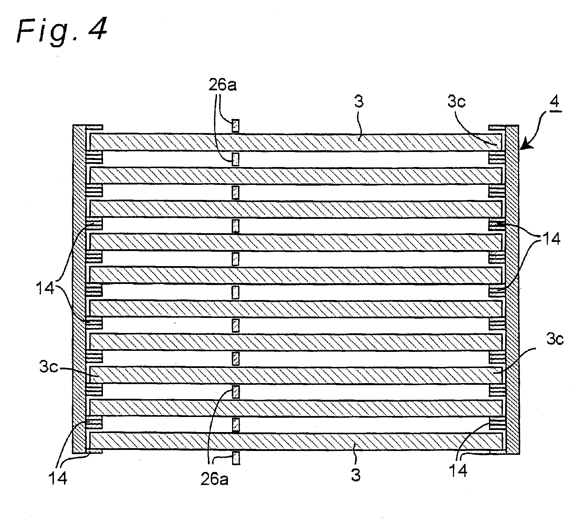

Fig. 4 shows a schematic partial sectional view of the cross section perpendicular to the pallet feed direction A of the magazine 4 in a state in which the pallets 3 are supported and loaded on the respective rack sections 14. As shown in Fig. 4, the support side edge portions 3c of the pallets 3 are supported in an engagement manner by the mutually opposed respective rack sections 14 in the magazine 4. In the above-mentioned state, the pallets 3 are stacked at the aforementioned regular intervals without being put in contact with one another with the roughly horizontal support postures thereof maintained with interposition of constant gaps.

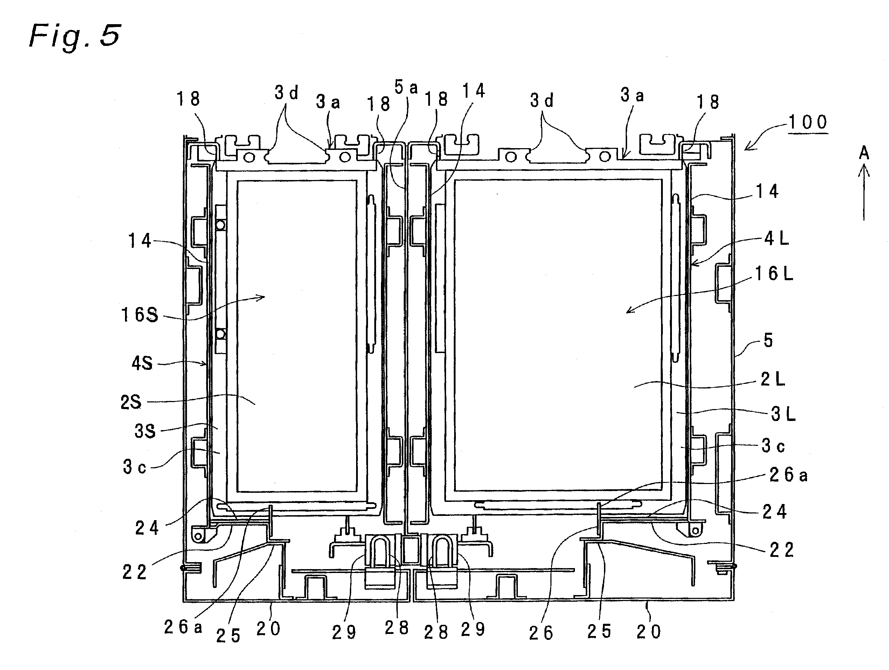

Next, a cross-sectional view taken along the line B-B of the electronic component feeder 100 of Fig. 2 is shown in Fig. 5. Although the state in which no pallet 3 is loaded in the magazine 4 is shown in the electronic component feeder 100 of Fig. 2, Fig. 5 shows a state in which the pallets 3 are loaded in the magazine 4 for the sake of easy understanding of the following description.

As shown in Fig. 5, two magazines 4 are mutually adjacently received in the main body section 5 of the electronic component feeder 100. A plurality of large-size pallets 3L on which large-size trays 2L are placed are loaded in a large-size magazine 4L located on the right-hand side in the figure, while a plurality of small-size pallets 3S on which small-size trays 2S are placed are loaded in a small-size magazine 4S located on the left-hand side in the figure. The magazines 4L and 4S can be individually moved up and down by mutually independent magazine elevation units 8.

Although an example in which two types of magazines 4 are received in the main body section 5 will be described in connection with the present embodiment, the present embodiment is not limited to this case but allowed to be applied to the case where only one type of magazine 4 is received or the case where three or more types of magazines 4 are received instead of the above-mentioned case.

In the following description, the large-size magazine 4L or the small-size magazine 4S is referred to as the magazine 4 when not limitedly used, and similarly, the large-size pallet 3L or the small-size pallet 3S is referred to as the pallet 3 when not limitedly used.

As shown in Fig. 5, the main body section 5 has an inner wall 5a. With this inner wall 5a served as a boundary, a large-size magazine receiving chamber 16L for receiving the large-size magazine 4L is formed on the right-hand side in the figure, and a small-size magazine receiving chamber 16S for receiving the small-size magazine 4S is formed on the left-hand side in the figure.

Moreover, as shown in Fig. 5, the large-size magazine receiving chamber 16L has forward guide sections 18 of one example of the forward-side regulating member for coming in contact with the neighborhood of both end portions of the forward side edge portion 3a of the large-size pallet 3L loaded in the magazine 4L and to regulate the movement position (or support position) on the forward side in the pallet feed direction of the large-size pallet 3L by the contact. Moreover, the forward guide sections 18, which are fixed to the main body section 5 so as to extend along the entire length in the vertical direction within the range of elevation of the large-size magazine 4L, are not provided in the portions corresponding to the pallet feed port 6 for unloading each pallet 3. It is to be noted that the small-size magazine receiving chamber 16S is similarly provided with forward guide sections 18.

Moreover, as shown in Fig. 5, the rearward side of the main body section 5 in the pallet feed direction A serves as the pallet loading side for carrying out loading, replacement or the like of each pallet 3, and the main body section 5 has two outer doors 20, which serve as one example of an openable receiver door section, on this pallet loading side. The outer doors 20 can be opened on both sides of the placement position of the inner wall 5a served as a boundary, and only one outer door 20 can be selectively opened independently. For example, when only the outer door 20 located on the right-hand side in the figure is opened, only the large-size magazine receiving chamber 16L can be opened.

On the rearward side in the pallet feed direction A, each magazine 4 has an inner door 22 of one example of the openable magazine door section for carrying out loading or the like of the pallets 3 in the magazine 4. Each of the inner doors 22 is formed so as not to cover the entire rearward side surface of the magazine 4 in the pallet feed direction A but to cover only about one third of the surface.

Further, the inner doors 22 of the large-size magazine 4L are internally provided with a rearward guide section 24, which is one example of the rearward-side regulating member for regulating the movement position (or support position) on the rearward side in the pallet feed direction A by being brought in contact with the rearward side edge portion 3b of each of the large-size pallets 3L loaded in the magazine 4L loaded in the large-size magazine receiving chamber 16L. This rearward guide section 24 is formed on the inner door 22 so as to extend from the upper end to the lower end of the magazine 4L in the vertical direction and is movable along the pallet feed direction A in accordance with the pivoting of the inner door 22. Further, in the magazine 4L, the inner door 22 is closed in a state in which both end portions of the forward side edge portion 3a of the large-size pallet 3L are brought in contact with the forward guide sections 18 and its movement position in the pallet feed direction A is regulated and in a state in which the rearward guide section 24 is brought in contact with the rearward side edge portion 3b of the large-size pallet 3L (i.e., the state shown in Fig. 5). Further, a bumper section 25 for bumping against the outside of the corresponding inner door 22 is formed inside the outer door 20, so that the outer door 20 can be completely closed with the bumper section 25 brought in contact with the outside of the inner door 22 only in a state in which the inner door 22 is completely closed as described above. Therefore, the outer door 20 is constructed unclosable in a state in which the corresponding inner door 22 is not completely closed, since the bumper section 25 is brought in contact with the outside of inner door 22 that is not closed and the pivotal position of the outer door 20 is regulated. It is to be noted that a rearward guide section 24 is similarly provided inside the inner door 22 of the small-size magazine 4S.

Moreover, as shown in Figs. 2, 4 and 5, a combteeth-shaped combteeth guide section 26 (one example of the horizontal posture regulating member), which has a plurality of projections 26a vertically arranged at the same formation interval as the formation interval of the rack sections 14, is provided inside each of the inner doors 22. The projections 26a in the combteeth guide section 26 can be arranged so as to be inserted in gaps between the pallets 3 loaded stacked in the magazine 4. In concrete, by closing the inner door 22 of the magazine 4L loaded with the large-size pallets 3L, the projections 26a can be inserted in the gaps between the large-size pallets 3L. As described above, it can be detected whether or not the large-size pallets 3L are each securely supported by a pair of mutually opposed rack sections 14, i.e., whether or not the large-size pallets 3L are each supported in a roughly horizontal support posture in the magazine 4 by inserting the projections 26a in the gaps.

Moreover, as shown in Fig. 4, each of the projections 26a of the combteeth guide section 26 has the height, so that each projection 26a is slightly smaller than the height dimension of the gap between the large-size pallets 3L in the stacked state, so that none of the projections 26a is brought in contact with the large-size pallets 3L when the large-size pallets 3L are each loaded in the state in which the roughly horizontal support posture is maintained.

Further, as shown in Fig. 5, each of the projections 26a has a length in the pallet feed direction A, so that the projection does not reach the region where the electronic components 1 in the large-size tray 2L placed on the large-size pallet 3L are arranged even in a state in which the projection 26a is arranged inserted between the large-size pallets 3L. Therefore, even in the case where electronic components 1 having an especially large height are arranged in the large-size tray 2L and the large-size tray 2L is placed on the large-size pallet 3L and loaded in the magazine 4L, the fore ends of the projections 26a of the combteeth guide section 26 do not come in contact with the electronic components 1 arranged in the large-size tray 2L, reliably preventing the occurrence of damages of the electronic components 1 due to the contact.

Moreover, as shown in Fig. 5, the combteeth guide sections 26 are arranged closer to the rack section 14 located on the right-hand side with respect to the position roughly intermediate between mutually opposed rack sections 14 in the magazine 4L, while the combteeth guide sections 26 are arranged closer to the rack section 14 located on the left-hand side with respect to the position roughly intermediate between mutually opposed rack sections 14 in the magazine 4S. The combteeth guide sections 26 are formed so as to extend from the upper end to the lower end of the magazine 4. Moreover, the combteeth guide sections 26 inserted between the large-size pallets 3L are provided on the inner door 22 of the large-size magazine 4L. With this arrangement, the combteeth guide sections 26 are moved up and down together with the large-size pallets 3L even if the large-size magazine 4L is moved up and down by the magazine elevation unit 8, and therefore, the elevation operation of the large-size magazine 4L is not hindered.

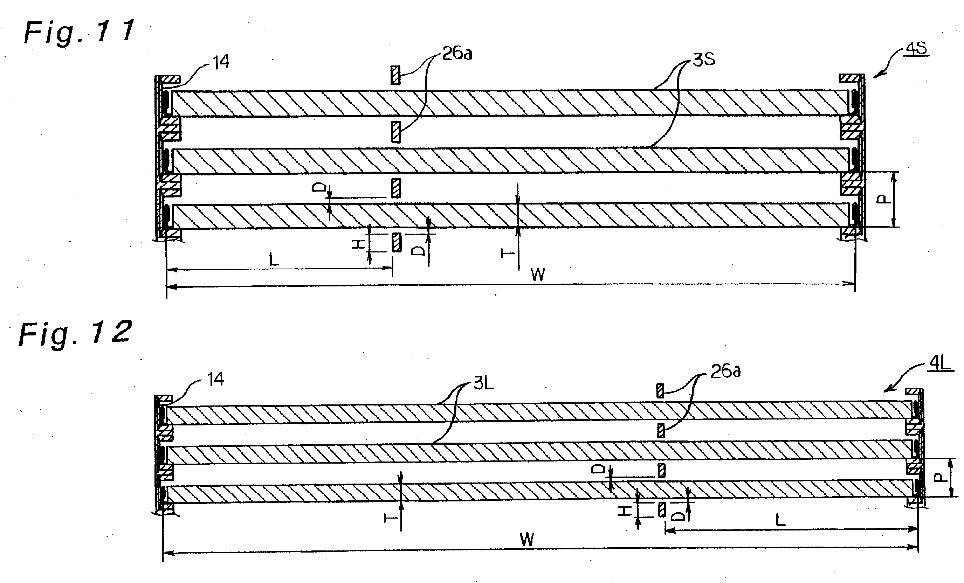

In this case, one example of the dimensions of the combteeth guide sections 26 is shown in Fig. 11 (a schematic partial sectional view of a cross section perpendicular to the pallet feed direction A) with regard to the small-size magazine 4S and in Fig. 12 (a schematic partial sectional view of a section similar to the above) with regard to the large-size magazine 4L. As shown in Fig. 11, in the small-size magazine 4S, the dimensions are set so that a width W between a pair of rack sections 14 is 170 mm, a interval (pitch) P of the rack sections 14 is 13.5 mm, a thickness T of the small-size pallet 3S is 6 mm, a height H of the projection 26a of the combteeth guide section 26 is 4.5 mm, a gap height D of a space between the upper surface or the lower side of the small-size pallet 3S and the nearmost projection 26a is 1.5 mm, and a distance L between each projection 26a and the rack section 14 (rack section 14 located on the adjacent side) is 56 mm. Moreover, as shown in Fig. 12, in the large-size magazine 4L, the dimensions are set so that a width W between a pair of rack sections 14 is 260 mm, a interval (pitch) P of the rack sections 14 is 13.5 mm, a thickness T of the large-size pallet 3L is 6 mm, a height H of the projection 26a of the combteeth guide section 26 is 4.5 mm, a gap height D of the space between the upper surface or the lower side of the large-size pallet 3L and the nearmost projection 26a is 1.5 mm, and a distance L between each projection 26a and the rack section 14 (rack section 14 located on the adjacent side) is 87 mm. It is preferable to set the distance L between each projection 26a and the rack section 14 to a dimension about one third of the width W between a pair of rack sections 14 (i.e., L = 1/3W or a dimension about one third of the width of the pallet 3) for the reasons described later.

Further, as shown in Fig. 5, each of the outer doors 20 is provided with a door opening/closing detection section for detecting the opening or closing of the outer door 20, and this door opening/closing detection section has a safety switch dog 28 provided in a lower portion of the open side end portion of each outer door 20 and a safety switch 29 engaged with the safety switch dog 28 in a state in which each outer door 20 is completely closed.

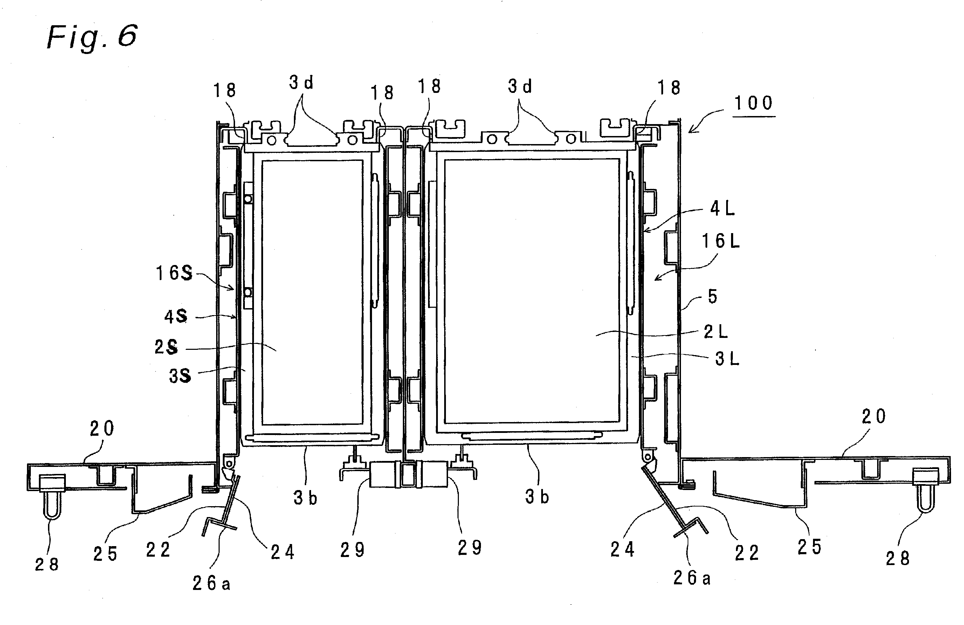

Fig. 6 shows a state in which the outer doors 20 and the inner doors 22 are opened at the electronic component feeder 100. In this state, the regulation of the movement position on the rearward side in the pallet feed direction A of the pallets 3 (i.e., the large-size pallets 3L and the small-size pallets 3S) loaded in the magazines 4L and 4S are released. Therefore, it is possible to carry out replacement of each pallet 3 by unloading, loading of a new pallet 3 and so on.

Moreover, as shown in Fig. 2, the electronic component feeder 100 has a control unit 9, for controlling the elevation operation of the magazines 4 by the respective magazine elevation units 8 and the detection of the open/closed state of each of the outer doors 20 by the respective safety switches 29 and safety switch dogs 28. The control unit 9 can execute the above-mentioned control operations in correlation with the control operation of a mounting control unit that controls the mounting operation of the electronic components 1 in the electronic component mounting apparatus 101.

In concrete, the control unit 9 can execute, for example, the control of the elevation operation by the magazine elevation unit 8 so that one pallet 3 loaded in the magazine 4 of the electronic component feeder 100 is selected according to the type of the electronic component 1 to be mounted on a circuit board and the selected pallet 3 is positioned in the height position of the pallet feed port 6 and putting the pallet 3 positioned in the height position into an unloadable state by the unloader 106.

Moreover, there is provided an interlock that stops the elevation operation by the magazine elevation unit 8 when the open state of the outer door 20 is detected by either the safety switch 29 or the safety switch dog 28 on the assumption that the loading state (support posture) of the pallet 3 loaded in either of the magazines 4L or 4S is abnormal. There is further provided a display section 19 that operates, when the open state of the outer door 20 as described above is detected, to display the information of the event while allowing the operator to recognize the information.

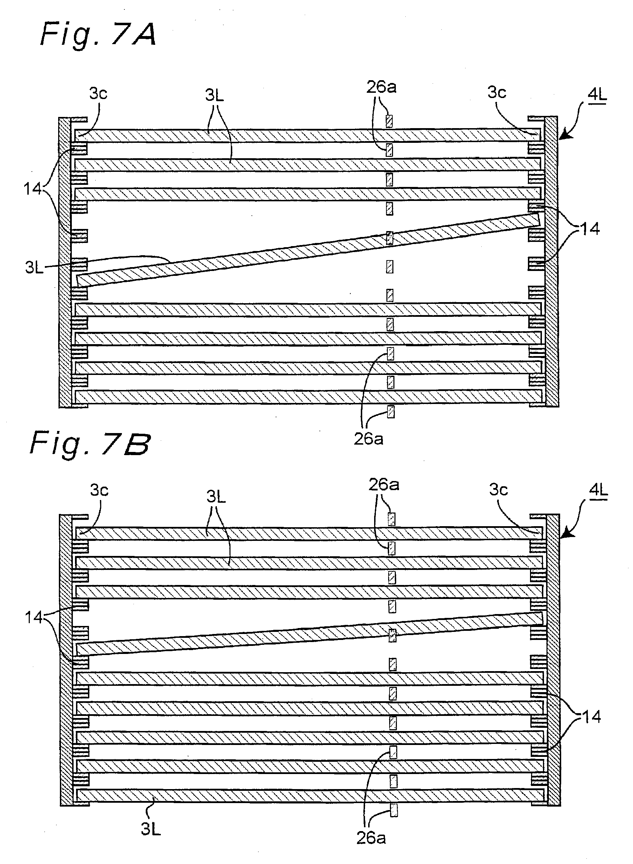

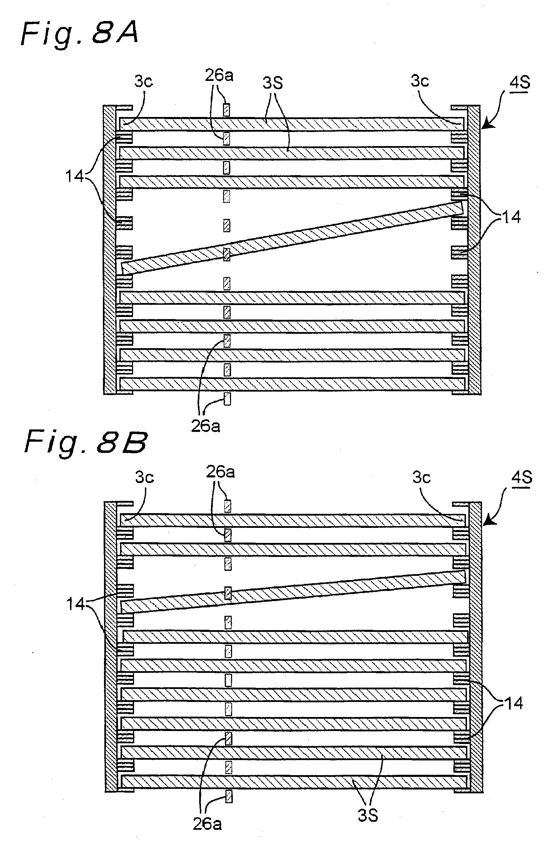

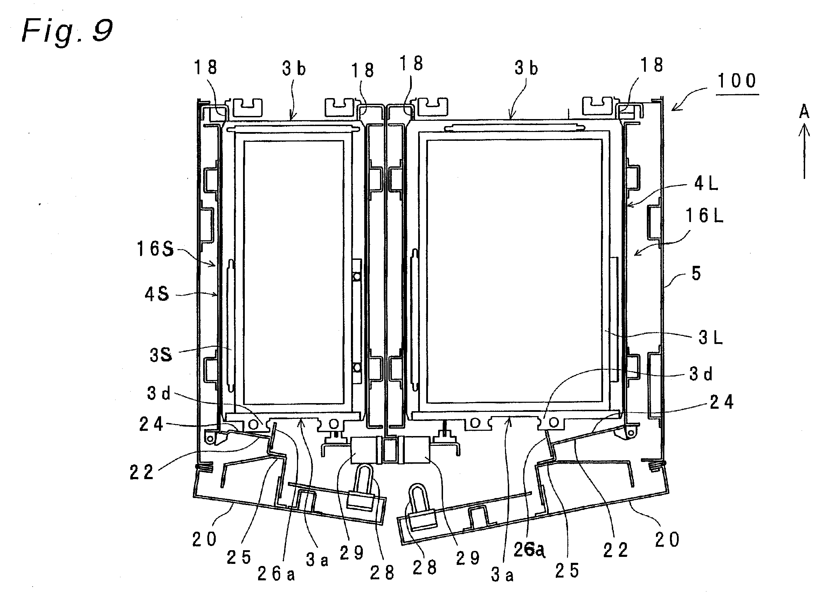

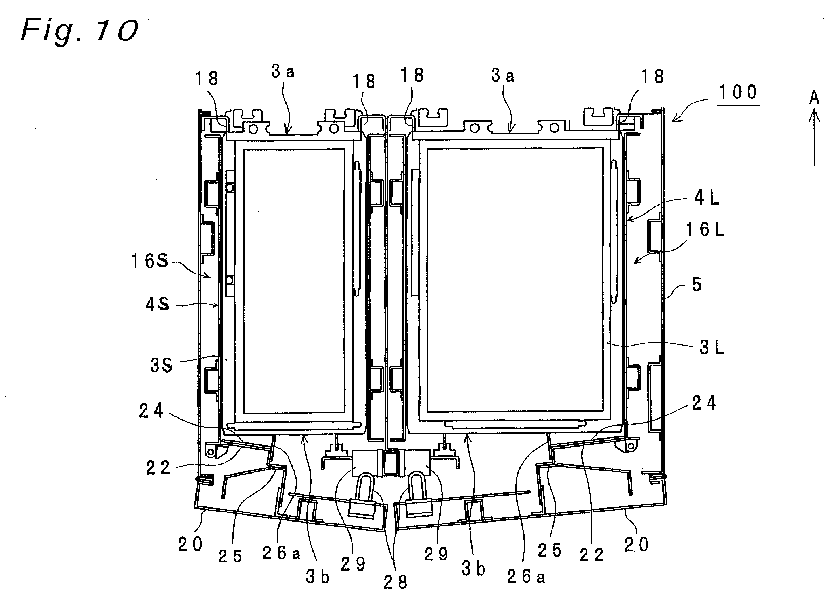

A method for detecting the occurrence of abnormality in the support posture (or loading posture) of the pallet 3 loaded in the magazine 4 in the electronic component feeder 100 of the aforementioned construction will be described below by way of a concrete example. Figs. 7A and 7B show schematic sectional views of a cross section perpendicular to the pallet feed direction A of the large-size magazine 4L in which the pallet 3 having the aforementioned abnormality in the support posture is loaded, while Figs. 8A and 8B show schematic sectional views of the small-size magazine 4S. Figs. 9 and 10 show schematic sectional views of a cross section perpendicular to the stacking direction of the pallet 3 in the electronic component feeder 100 in such the state.

First of all, Figs. 4 and 5 show a state in which the pallets 3 are loaded in the normal support posture in the magazine 4 of the electronic component feeder 100. There are two requirements for the loaded pallet 3 to keep this normal support posture in the magazine 4. As the first requirement, the forward side edge portion 3a of the pallet 3 is required to be directed in the pallet feed direction A (this arrangement is referred to as a forwardly directed support posture in the pallet feed direction A) as shown in Fig. 5. Further, as the second requirement, the support side end portions 3c of the pallet 3 are required to be supported by a pair of mutually opposed rack sections 14, i.e., in the state in which the roughly horizontal support posture is maintained as shown in Fig. 4. If either one of the above-mentioned requirements is not satisfied, the pallet 3 is loaded not in the correct support posture, and there is abnormality in the support posture. In the above case, there possibly occur not only hindrance in the elevation operation of the magazine 4 by the magazine elevation unit 8 and the unloading operation of the pallet 3 by the unloader 106 but also the damage of the pallet 3 and the electronic component feeder 100 itself due to the operation.

As shown in Fig. 9, in the small-size magazine receiving chamber 16S in the electronic component feeder 100, the forward side edge portion 3a of the small-size pallet 3S is arranged so as to direct in the direction reverse to the pallet feed direction A (i.e., this posture is referred to as a reversely directed support posture in the pallet feed direction A). In concrete, end portions of the rearward side edge portion 3b of the small-size pallet 3S are brought in contact with the forward guide sections 18, so that the support position on the forward side in the pallet feed direction A is regulated by this contact. If it is tried to close the inner door 22 of the small-size magazine 4S in the above-mentioned state, the protruding grip portion 3d formed at the forward side edge portion 3a of the small-size pallet 3S is brought in contact with the rearward guide section 24 provided inside the inner door 22, as a consequence of which the position where the small-size pallet 3S is brought in contact with the rearward guide section 24, i.e., the pivotal position of the inner door 22 is limited and put into the unclosable state. Further, the bumper section 25 of the outer door 20 (outer door 20 for the small-size magazine receiving chamber 16S) is brought in contact with the outside of the inner door 22, and the pivoting for closing the outer door 20 itself is limited, failing in completely closing the door. In this case, since the safety switch dog 28 of the outer door 20 cannot be engaged with the safety switch 29, it is possible to make the control unit 9 display the event that the outer door 20 cannot be completely closed in the display section 19 and let the operator recognize the event. The operator, who has recognized the display, is able to recognize that the small size pallet 3S having abnormality in its support posture is included in the small-size magazine 4S, i.e., the inclusion of the small-size pallet 3S loaded in the reversely directed support posture and to take necessary measures. The recognition method (detection method) of the pallet 3 in the case where the reversely directed pallet 3 is included in the magazine 4 can be similarly carried out for the large-size magazine 4L.

Moreover, the plurality of large-size pallets 3L are loaded in the large-size magazine 4L as shown in Fig. 7A, where one large-size pallet 3L is put in a state in which the pallet is supported by rack sections 14 one of which is displaced by two steps without being supported by one pair of mutually opposed rack sections 14 by its side edge portions 3c. That is, the support side edge portions 3c are supported by the rack sections 14 that are not mutually opposed and put in a state in which the pallet is supported in an inclined support posture without maintaining the roughly horizontal support posture.

In the above case, if it is tried to close the inner door 22 of the large-size magazine 4L as shown in Fig. 10, then the end portion of the projection 26a of the combteeth guide section 26 provided inside the inner door 22 comes in contact and interferes with the rearward side edge portion 3b of the large-size pallet 3L in the inclined support posture (see Fig. 7A). Therefore, the pivotal position of the inner door 22 is limited (regulated) without inserting the projections 26a of the combteeth guide section 26 between the large-size pallets 3L, failing in completely closing the door. The pivoting of the outer door 20 (outer door 20 for the large-size magazine receiving chamber 16L) in the state in which the bumper section 25 is brought in contact with the outside of the inner door 22 is also limited (regulated), failing in completely closing the door. As a result, since the safety switch dog 28 of the outer door 20 cannot be engaged with the safety switch 29, it is possible to make the control unit 9 display the event that the outer door 20 cannot be completely closed in the display section 19 to let the operator recognize the event. The operator, who has recognized the display, is able to recognize that the large-size pallet 3L loaded in the inclined support posture is included in the large-size magazine 4L and to take necessary measures. If the projection 26a of the combteeth guide section 26 is brought in contact with the large-size pallet 3L as described above, the projection 26a does not interfere directly with the large-size tray 2L and the electronic components 1 arranged on this large-size tray 2L since the position of contact is the edge portion of the large-size pallet 3L. The recognition method (detection method) of the pallet 3 in the case where the pallet 3 in the aforementioned inclined support posture is included in the magazine 4 can be similarly carried out for the small-size magazine 4S as shown in Fig. 10.

The state of the large-size magazine receiving chamber 16L shown in Fig. 9 shows a state in which a large-size pallet 4L having the reversely directed support posture and the inclined support posture is loaded in the large-size magazine 4L. In this state, the projection 26a of the combteeth guide section 26 is brought in contact with the forward side edge portion 3a of the large-size pallet 3L, and the insertion of the projections 26a is limited, so that the inner door 22 and the outer door 20 cannot be completely closed.

Moreover, the formation height of the projections 26a and the arrangement of the combteeth guide section 26 in the horizontal direction in Figs. 7A and 7B are determined so that the projections 26a of the combteeth guide section 26 interfere with not only the large-size pallet 3L that has the inclined support posture and is supported by rack sections 14 displaced by two steps by its side edge portions 3c in the large-size magazine 4L as shown in Fig. 7A but also the large-size pallet 3L that has the inclined support posture and is supported by rack sections 14 displaced by one step. By thus forming and arranging the combteeth guide section 26, the inclined support postures displaced by one step, two steps or the like, which tends to be rather neglected by the operator, can reliably be detected.

It is to be noted that Figs. 8A and 8B show the state of the small-size magazine 4S corresponding to the large-size magazine 4L described with reference to Figs. 7A and 7B. Since similar contents as those of the description of Figs. 7A and 7B are possessed, no description is provided for the figures.

Moreover, when the abnormality of the support posture of the pallet 3 in the magazine 4 is detected by the limited closing of the outer door 20, it is possible to interlockingly stop the driving of the magazine elevation unit 8 by the control unit 9 and further stop the operation of the electronic component mounting apparatus 101 equipped with the electronic component feeder 100.

Although there has been described hereinabove the case where the plurality of projections 26a inserted between the pallets 3 are formed in the combteeth guide section 26 that regulates the roughly horizontal support posture of the pallets 3 and is able to detect the inclined support posture, the present embodiment is not limited only to the above-mentioned case. In place of the above-mentioned case, it is acceptable to form, for example, a plurality of rod-shaped or plate-shaped members so that the members are provided along the side surface on which the rack sections 14 are formed and are arranged between the pallets 3 in the magazine 4. In this case, there is an advantage that the loading itself of the pallet 3 in the inclined support posture can be prevented since the horizontal support posture of the pallet 3 is regulated when the pallet is loaded in the magazine 4.

Moreover, although one example of the configuration of the pallet 3 used for the electronic component feeder 100 is shown in Fig. 3, the configuration is not limited only to such the configuration. Any configuration can be used in place of that of Fig. 3 so long as the configuration is accepted in the magazine 4 and the regulated position (position in which the pallet 3 is brought in contact with the rearward guide section 24) by the rearward guide section 24 is different between the forwardly directed support posture and the reversely directed support posture in the state in which the support position on the forward side is regulated by the forward guide section 18.

Moreover, there has been described the case where the tray 2, on which the plurality of electronic components 1 are arranged in alignment, is placed on the upper surface of the pallet 3 as shown in Fig. 3. However, in place of this arrangement, it is acceptable to integrally form the tray 2 with the pallet 3 and load the tray 2 directly into the magazine 4 instead of the pallet 3.

By making it possible to easily identify the combination of a pair of rack sections 14 with a serial number or an identification color attached to the rack sections 14 of each magazine 4 so that a pair of rack sections 14 has an identical number or an identical color in place of or in addition to the method of preventing the insertion of the pallet 3 in the inclined support posture into the magazine 4 as described above, it is possible to attract the operator's attention in advance.

Moreover, it is also possible to provide the pallets 3 individually with a level and display a warning for attracting the operator's attention (by using, for example, a color display or the like) with the level when the pallet 3 is inserted in the inclined support posture into the magazine 4.

Moreover, it is also acceptable to use a method for flowing and a feeble current through the mutually paired rack sections 14 in a pair of rack sections 14 in the magazine 4 and detecting the current when the pallet 3 is inserted in the normal support posture.

According to the first embodiment, the following various effects can be obtained.

First of all, the electronic component feeder 100 has the forward guide section 18 that regulates the support position of each pallet 3 loaded in the magazine 4 by the rack sections 14 by being brought in contact with the edge portion of pallet 3 on the forward side in the pallet feed direction A and the rearward guide section 24 that is provided for the inner door 22 movably along the pallet feed direction A and regulates the pallet 3 regulated by the forward guide section 18 by being brought in contact with the edge portion of the pallet 3 on the rearward side in the pallet feed direction A. With this arrangement, when the pallet 3, which is provided with the grip portions 3d at the forward side edge portion 3a thereof and formed so as to have mutually different forward side and the rearward side edge configurations, is loaded in magazine 4, it can be detected that the pallet 3 loaded in the reversely directed support posture is included among the loaded pallets 3 on the basis of the difference in the regulation position (contact position) by the rearward guide section 24.

Furthermore, by providing the inner door 22 with the combteeth guide section 26, where a plurality of projections 26a to be inserted in the gaps between the pallets 3 loaded in the magazine 4 are formed, when all the projections 26a are inserted in the gaps, it can be detected that the pallets 3 are loaded with the roughly horizontal support posture maintained without being inclined. When any projection 26a comes in contact and interferes with the edge portion of any pallet 3, failing in inserting the projections 26a in the gaps, it can be detected that there is included a pallet 3 in the inclined support posture.

Moreover, the inner door 22 is provided with the rearward guide section 24 and the combteeth guide section 26. There is the arrangement that the inner door 22 can be closed in the position where the edge portion of the pallet 3 loaded in the forwardly directed support posture is brought in contact with the rearward guide section 24, the inner door 22 cannot be closed in the position where the edge portion of the pallet 3 loaded in the reversely directed support posture is brought in contact with the rearward guide section 24, and the inner door 22 cannot be closed even when the combteeth guide section 26 interferes with the pallet 3. With this arrangement, it can be detected whether or not there is abnormality in the support posture of each pallet 3 in the magazine 4, i.e., whether or not there is included a pallet 3 in the reversely directed support posture or the inclined support posture based on whether or not the inner door 22 can be closed.

Therefore, the abnormality of the support posture of each pallet 3 loaded in the magazine 4 can be reliably easily detected and the pallet 3 can be loaded consistently in the correct support posture in the electronic component feeder 100. Therefore, the operation stop of the electronic component mounting apparatus 101 attributed to the above-mentioned support postures of the pallets 3 and damages or the like of the constituent components of the electronic component feeder 100 can be prevented.

Moreover, the electronic component feeder 100 is provided with the outer door 20 that can be closed only when the inner door 22 is closed, the safety switch 29 and the safety switch dog 28 for detecting the opening/closing of this outer door 20 and further the display section 19 that can display this result of the opening/closing while allowing the operator to recognize the result, the operator is allowed to more reliably recognize the open/closed state of the inner door 22.

Moreover, with the inner door 22 provided for the magazine 4 and the outer door 20 provided for the main body section 5 as described above, the inner door 22 can be moved up and down integrally with the magazine 4, and the elevation operation of the magazine 4 is not hindered even when the combteeth guide section 26 is provided for the inner door 22.

Moreover, with the combteeth guide section 26 positioned not in the vicinity of the position intermediate between the mutually opposed rack sections 14 in the magazine 4 but closer to either one of the rack sections 14 away from the intermediate position, the projection 26a of the combteeth guide section 26 can more reliably come in contact and interfere with the pallet 3 in the inclined support posture.

Moreover, by virtue of the arrangement that the combteeth guide section 26 is arranged in position so as to interfere with the pallet 3 supported by the rack sections 14 displaced by two steps and the pallet 3 supported by the rack sections 14 displaced by one step and the arrangement that the dimensional relation between the formation height of each projection 26a and the gap between the pallets 3 is determined as described above, the inclined support postures displaced by one step and by two steps, which tend to be rather neglected by the operator, can reliably be detected.

Moreover, each projection 26a has the dimension of length so that the end of each projection 26a of the combteeth guide section 26 does not reach the region where the electronic components 1 are arranged in the tray 2 placed on the pallet 3 even when the inner door 22 is completely closed, the projection 26a is prevented from coming in contact with the electronic components 1 and from damaging the electronic components 1 in any case. Since comparatively expensive electronic components 1 such as IC chips are arranged on the tray 2 as described above, the capability of preventing the occurrence of damages of electronic components 1 as described above also reduces the manufacturing cost in component mounting and allows efficient component mounting to be achieved.


(Second Embodiment)

The present invention is not limited to the aforementioned embodiment but allowed to be put into practice in various other forms. For example, a tray plate structure capable of carrying out stable efficient electronic component feeding while preventing the leap-up or the like of the electronic component from the component feed tray by devising a method for fixing the component feed tray on the tray plate of one example of the pallet in the electronic component feeder 100 of the first embodiment or an electronic component feeder that has another construction will be described below as the second embodiment of the present invention.

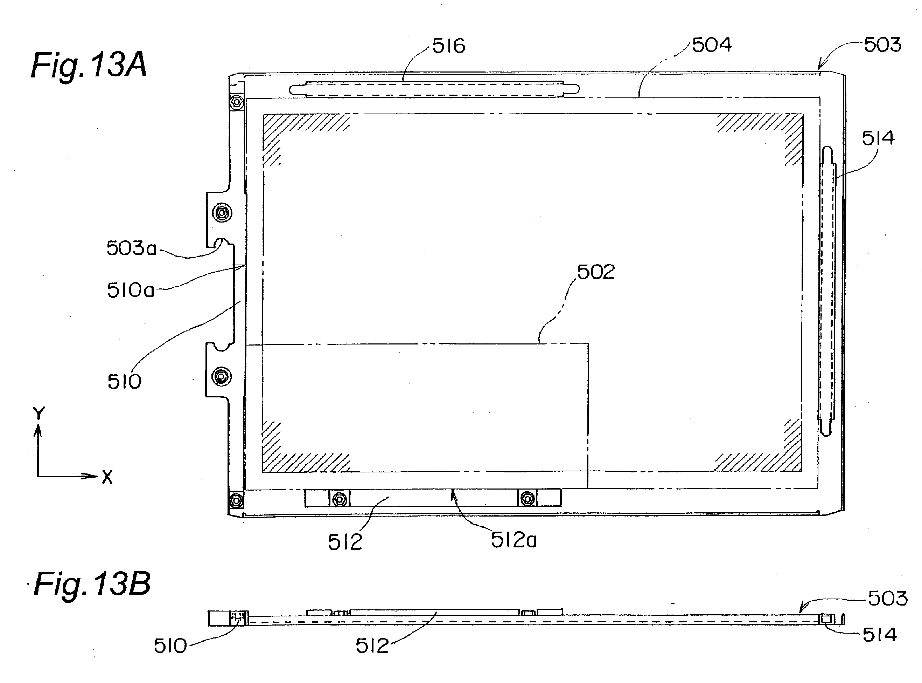

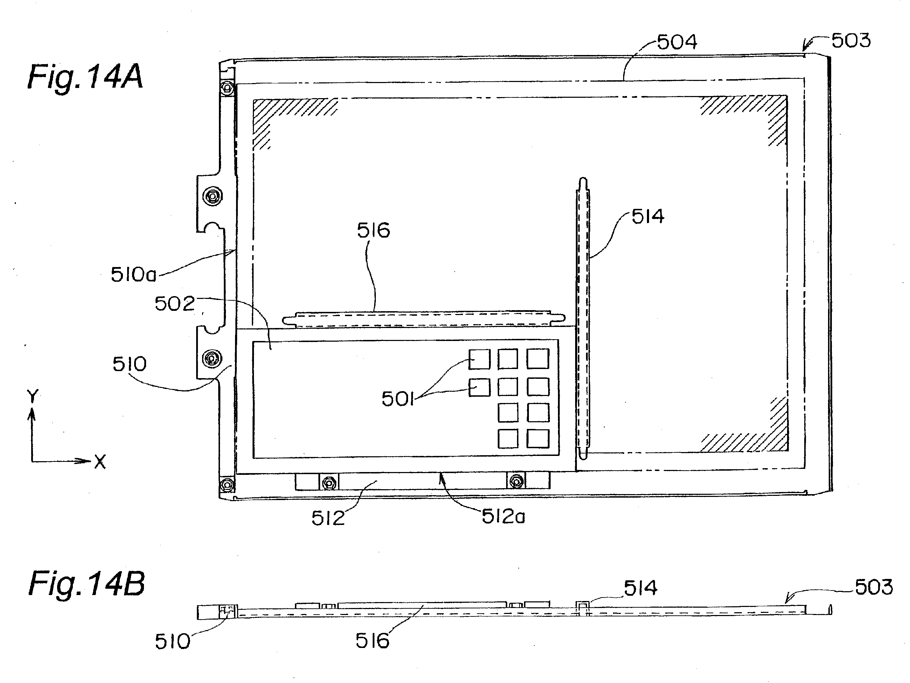

Fig. 13A shows a plan view of a tray plate 503 of one example of the placement section where the component feed tray handled in the electronic component feeder according to the present second embodiment is placed (also as one example of the pallet), and Fig. 13B shows its side view. Moreover, Fig. 14A shows a plan view in a state in which the component feed tray is placed on this tray plate 503, and Fig. 14b shows its side view.

As shown in Figs. 13A, 13B, 14A and 14B, the tray plate 503 has a roughly flat-plate-like rectangular shape and includes a placement surface (this may be a placement region) that receives a component feed tray 502 on which a plurality of electronic components 501 of one example of the electronic components are arranged while allowing the components to be picked up on its upper surface. This tray placement surface 504 is formed as a roughly quadrangular flat surface region formed within the upper surface of the tray plate 503 surrounded by the peripheral portions. A component feed tray 502 can be arranged so as to be positioned on this tray placement surface 504.

Such the tray plate 503 is used for feeding electronic components to a component mounting apparatus for mounting the electronic components on a circuit board. The plurality of the tray plates 503, each of which carries the component feed tray 502 placed thereon, are loaded in layers in a magazine or the like and unloaded from the magazine according to the type of the electronic components to be mounted on the circuit board. The desired electronic component is sucked and held and picked up from the component feed tray 502 placed on the unloaded tray plate 503 by a suction nozzle of one example of the component suction and holding member of the component mounting apparatus, and the electronic components can be mounted onto the circuit board by the component mounting apparatus.

The construction of this tray plate 503 will be described in detail as follows. As shown in Figs. 13A and 13B, an engagement portion 503a having a concave configuration is formed at the end portion, which is located on the left-hand side in the figure, of the tray plate 503. By engaging this engagement portion 503a with a pullout portion of a tray plate pullout unit (not shown), the tray plate 503 can be advanced and retreated in the illustrated X-axis direction. With this movable arrangement, for example, the tray plate 503 loaded in the magazine can be pulled out of the magazine or loaded into the magazine by the advancing and retreating movement.

Moreover, as shown in Figs. 13A and 13B, the component feed tray 502 is placed on the tray placement surface 504 of the tray plate 503 with the illustrated lower left corner portion served as a reference position. Therefore, the tray plate 503 is provided with an X-axis direction reference position regulating member 510 (hereinafter referred to as an X-axis reference member 510) of one example of the reference position regulating member for regulating the movement of the component feed tray 502 arranged in the reference position leftward in the illustrated X-axis direction and a Y-axis direction reference position regulating member 512 (hereinafter referred to as a Y-axis reference member 512) of one example of the reference position regulating member for regulating the movement downward in the illustrated Y-axis direction. This X-axis reference member 510 has an X-axis direction reference surface 510a (hereinafter referred to as an X-axis reference surface 510a), which is formed along the illustrated Y-axis direction and able to regulate the component feed tray 502 in the X-axis direction (i.e., lengthwise direction) by being brought in contact with the end portion of the component feed tray 502. The Y-axis reference member 512 has a Y-axis direction reference surface 512a (hereinafter referred to as a Y-axis reference surface 512a), which is formed along the illustrated X-axis direction and able to regulate the component feed tray 502 in the Y-axis direction (i.e., horizontal direction) by being brought in contact with the end portion of the component feed tray 502. In the present second embodiment, the X-axis direction and the Y-axis direction are the directions along the surface of the tray placement surface 504 and mutually perpendicular directions. Moreover, the X-axis reference member 510 and the Y-axis reference member 512 are fixed to the neighborhood of the respective edge portions of the tray plate 503 by, for example, being screwed or other means. In the present second embodiment, for example, the engagement portion 503a is formed integrally with the X-axis reference member 510 and formed on the surface opposite from the surface located on the side on which the X-axis reference surface 510a is formed at the X-axis reference member 510.

Moreover, as shown in Figs. 13A and 13B, the tray plate 503 is provided with an X-axis direction fixation bar 514 (hereinafter referred to as an X-axis fixation bar 514) of one example of the fixation bar that has a rod-shaped configuration and is able to regulate the rightward movement in the illustrated X-axis direction of the component feed tray 502 in the state in which its respective end portions are brought in contact with the X-axis reference surface 510a of the X-axis reference member 510 and the Y-axis reference surface 512a of the Y-axis reference member 512 and a Y-axis direction fixation bar 516 (hereinafter referred to as a Y-axis fixation bar 516) of one example of the fixation bar that has a rod-shaped configuration and is able to regulate the upward movement in the illustrated Y-axis direction of the component feed tray 502 in the above-mentioned state. The X-axis fixation bar 514 and the Y-axis fixation bar 516 have, for example, a mutually identical configuration and are able to magnetically releasably fix their arrangement positions in arbitrary positions on the tray placement surface 504 by means of built-in magnets.

Figs. 14A and 14B show a state in which the placement position of the component feed tray 502 placed on the tray placement surface 504 by means of the X-axis fixation bar 514 and the Y-axis fixation bar 516 as described above. As shown in Figs. 14A and 14B, with respect to the end portions of the component feed tray 502 in the state in which the movement thereof in the illustrated X-axis leftward direction and Y-axis downward direction are regulated by bringing the end portions in contact with the X-axis reference member 510 and the Y-axis reference member 512 on the tray placement surface 504 of the tray plate 503, the X-axis fixation bar 514 and the Y-axis fixation bar 516 are arranged on the tray placement surface 504 so as to be brought in contact with the end portions located on the sides opposite (i.e., the opposite sides) from the end portions. Further, by magnetically fixing the bars arranged, the rightward movement in the illustrated X-axis direction and the upward movement in the illustrated Y-axis direction of the component feed tray 502 can also be regulated. Therefore, the placement position of the component feed tray 502 on the tray placement surface 504 can be fixed in the illustrated X-axis direction and Y-axis direction, i.e., in the direction (i.e., the first direction) along the surface of the tray placement surfaces 504.

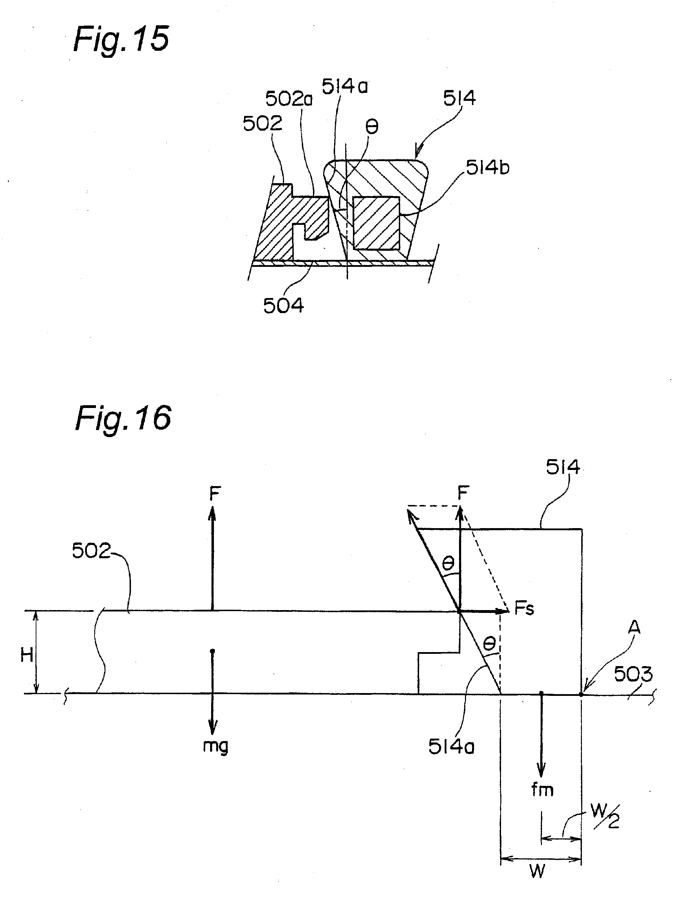

Fig. 15 shows a schematic sectional view showing the structure of the X-axis fixation bar 514 and the Y-axis fixation bar 516. In the present second embodiment, the X-axis fixation bar 514 and the Y-axis fixation bar 516 have a mutually identical structure, and therefore, Fig. 15 shows the cross section of the X-axis fixation bar 514 as a representative of them.

As shown in Fig. 15, the X-axis fixation bar 514 has a fixation surface 514a, which fixes the placement position of the component feed tray 502 in the X-axis direction by being brought in contact with the end portion 502a of the component feed tray 502. This fixation surface 514a is formed inclined at, for example, a prescribed angle θ with respect to a plane perpendicular to the tray placement surface 504. In other words, the surface is formed inclined at a prescribed angle (90° - θ°) without being perpendicular to the tray placement surface 504. This fixation surface 514a is formed so as to incline toward the component feed tray 502 side to be brought in contact vertically upwardly in Fig. 15. With the fixation surface 514a formed as described above, it becomes possible to regulate the movement in the horizontal direction in the figure (i.e., X-axis direction) of the component feed tray 502 brought in contact with this fixation surface 514a and to regulate also the movement in the vertical direction in the figure. Therefore, by employing the X-axis fixation bar 514 and the Y-axis fixation bar 516 that have the above-mentioned structure, it becomes possible to fix the component feed tray 502 in the illustrated X-axis direction and Y-axis direction on the tray placement surface 504 and to concurrently fix the tray in the direction perpendicular to the tray placement surface 504.

The inclined fixation surface 514a of the X-axis fixation bar 514 serves as one example for the fixation in the first direction that is the direction along the surface of the tray placement surface 504 (or one example of the first direction fixation portion) and also serves as one example for the fixation in a second direction that is the direction perpendicular to the surface of the tray placement surface 504 (or one example of the second direction fixation portion). That is, the fixation surface 514a concurrently serves as the first direction fixation surface and the second direction fixation surface formed as an identical surface.

Moreover, as shown in Fig. 15, such the fixation surface 514a is formed on the other side of the X-axis fixation bar 514. With the fixation surface 514a formed on both sides, the cross-sectional configuration of the X-axis fixation bar 514 can be made symmetrical, and either fixation surface 514a of the X-axis fixation bar 514 can be used. Therefore, the handlability can be made satisfactory.

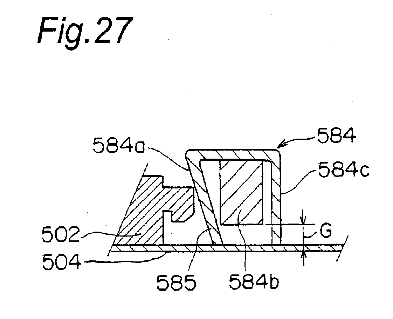

Moreover, instead of the case where the thus inclined fixation surfaces 514a are formed on both sides as described above, it is acceptable to form the inclined fixation surface 584a only on either one side as the X-axis fixation bar 584 shown in Fig. 27 and form a roughly perpendicular fixation surface 584c on the other side. In this case, the replacing work of the component feed tray 502 can be facilitated by fixing the component feed tray 502 by the roughly perpendicular fixation surface 584c. In this case, in order to assure reliable fixation, it is required that the warp of the component feed tray 502 is comparatively small, the weight of the component 501 accommodated in the component feed tray 502 is comparatively heavy, and the leap-up of the component 501 from the component feed tray 502 hardly occurs. Moreover, by fixing the component feed tray 502 by the inclined fixation surface 584a, the fixation of the component feed tray 502 can be made reliable. Particularly, when the warp of the component feed tray 502 is comparatively large, the strength is comparatively small and the weight of the component 501 accommodated in the component feed tray 502 is comparatively light, the fixation of the component feed tray 502 can be effectively achieved. That is, it becomes possible to select an optimum fixation method by selecting between the fixation surfaces according to the features of the component feed tray 502 of the object to be fixed. When the component feed tray 502 is fixed by the inclined fixation surface 584a, the fixed component feed tray 502 can be pressed against the tray placement surface 504 of the tray plate 503. Therefore, the component feed tray 502 and the tray plate 503 can be put in an integrated state, and the strength of the component feed tray 502 and the tray plate 503 can be improved. The tray plate 503 can be formed of a sheet metal having a thickness of, for example, about 0.5 mm.

Moreover, as shown in Fig. 15, a magnet section 514b, which is one example of the magnetic member formed of a magnetic material, is built in a lower portion of the X-axis fixation bar 514, so that the X-axis fixation bar 514 can be magnetically releasably fixed in the desired position on the tray placement surface 504. Moreover, as shown in Fig. 27, by providing a gap G between the lower surface of the magnet section 584b and the tray placement surface 504, there can be obtained a stronger magnetic field than in the state in which the lower surface of the magnet section 584b is brought in contact with the tray placement surface 504. It is to be noted that the member, which forms the fixation surfaces 584a and 584c of the X-axis fixation bar 584, is formed by bending, for example, an iron plate.

Here, Fig. 16 shows a schematic explanatory view showing forces generated in the X-axis fixation bar 514 and the Y-axis fixation bar 516 (note that the forces generated in the X-axis fixation bar 514 are typified) when erroneous suction is carried out by the suction nozzle on, for example, the component feed tray 502 in the state in which the placement position thereof is fixed and a suction force F is applied. In Fig. 16, it is assumed that the suction force applied to the component feed tray 502 by the suction nozzle is F, the dead weight of the component feed tray 502 is mg (g: gravitational acceleration), magnetic retentivity in the X-axis fixation bar 514 is fm, the inclination angle of the fixation surface 514a of the X-axis fixation bar 514 is θ, a horizontal component of force generated in the fixation surface 514a of the X-axis fixation bar 514 due to the suction force F is Fs, the width dimension of the lower surface of the X-axis fixation bar 514 is W, and the height (thickness) dimension of the component feed tray 502 is H.

First of all, in order to prevent the uplift of the component feed tray 502 from the tray plate 503 when the erroneous suction is carried out on the component feed tray 502 by the suction nozzle, it is required to satisfy the condition of the expression (1).

$$F < (mg + fm) \qquad \ldots (1)$$

Moreover, taking a moment generated around a point A at an end portion on the lower surface of the X-axis fixation bar 514 in Fig. 16 into consideration, it is required to satisfy the condition of the expression (2).

$$Fs \times H < fm \times W/2 \qquad \ldots (2)$$

The horizontal component of force Fs generated on the fixation surface 514a of the X-axis fixation bar 514 is expressed by the expression (3).

$$Fs = F \times \tan\theta \qquad \ldots (3)$$

Therefore, the inclination angle θ of the fixation surface 514a can be determined on the basis of the aforementioned conditions. The inclination angle θ can be determined within a range of, for example, about 1° to 30°.

Moreover, when the tray plate 503 on which the component feed tray 502 is placed is moved by being pulled out of the magazine, a horizontal force K based on the acceleration α due to the movement is to be generated in the component feed tray 502, and this horizontal force K is expressed by the expression (4).

$$K = mg \times \alpha \qquad \qquad \ldots (4)$$

Moreover, also in the state in which the horizontal force K is applied to the component feed tray 502, there is needed the condition of the expression (5) in order to reliably fix and hold the component feed tray 502 on the tray plate 503. It is to be noted that $\mu$ is the coefficient of friction between the lower surface of the X-axis fixation bar 514 and the tray plate 503.

$$K < fm \times \mu \qquad \qquad \ldots (5)$$

Moreover, taking the moment generated around the point A at the end portion on the lower surface of the X-axis fixation bar 514 in Fig. 16 into consideration, it is required to satisfy also the condition of the expression (6).

$$K \times H < fm \times W/2 \qquad \qquad \ldots (6)$$

Therefore, the height (thickness) H of the component feed tray 502, the width dimension L of the lower surface of the X-axis fixation bar 514 and further the magnetic retentivity fm in the X-axis fixation bar 514 can be determined on the basis of the aforementioned conditions.

It is to be noted that the constructions of the X-axis fixation bar 514 and the Y-axis fixation bar 516, which are the fixation bars of the present second embodiment, are not limited to the aforementioned constructions but allowed to adopt other constructions. Several modification examples concerning the fixation bars will be described below.

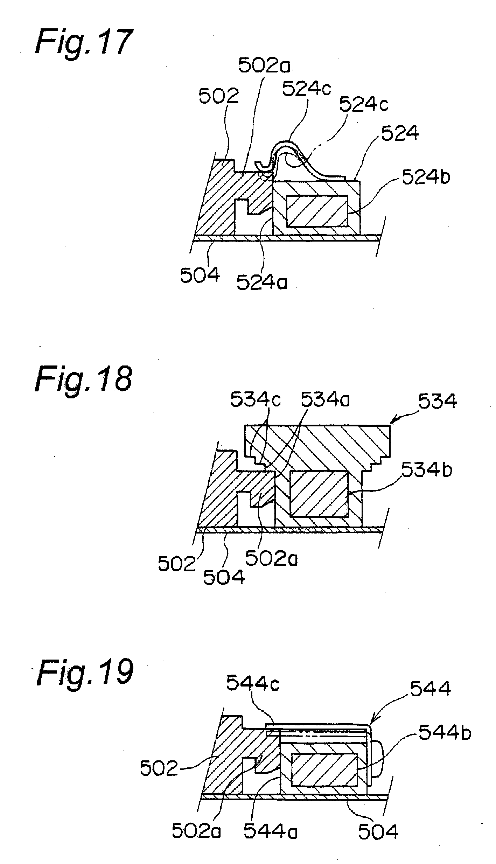

First of all, Fig. 17 shows a schematic sectional view of, for example, an X-axis fixation bar 524 of one example of the fixation bar according to a first modification example of the present second embodiment. As shown in Fig. 17, the X-axis fixation bar 524 is provided with a horizontal direction fixation surface 524a, which serves as one example of the first direction fixation portion and also as one example of the first direction fixation surface to fix the placement position of the component feed tray 502 in a direction along the surface of the tray placement surface 504 by being brought in contact with an end portion 502a of the component feed tray 502, and a vertical direction fixation spring (one example of the urging member) 524c, which serves as one example of a second direction fixation portion and also as a second direction fixation surface to fix the placement position of the component feed tray 502 in the direction perpendicular to the tray placement surface 504 by being brought in contact with an upper portion of the end portion 502a of the component feed tray 502 brought in contact with the horizontal direction fixation surface 524a and always urging the end portion 502a toward the tray placement surface 504.

Moreover, as shown in Fig. 17, the horizontal direction fixation surface 524a is formed so as to be roughly perpendicular to the tray placement surface 504 and able to come in surface contact with the end surface of the end portion 502a of the component feed tray 502 formed similarly roughly perpendicularly. Further, the vertical direction fixation spring 524c has one end fixed to an upper portion of the X-axis fixation bar 524 and is able to downwardly urge the end portion 502a with the other end brought in contact with the upper portion of the end portion 502a of the component feed tray 502.

It is to be noted that a magnet section 524b, which is one example of the magnetic material, is also built in the X-axis fixation bar 524 similarly to the X-axis fixation bar 514, so that the bar can be magnetically fixed in an arbitrary position on the tray placement surface 504.

By using the X-axis fixation bar 524 and the Y-axis fixation bar that has a similar structure, the placement position of the component feed tray 502 can be fixed in the horizontal direction and the vertical direction. Moreover, by forming the vertical direction fixation spring 524c so that the urging force of the vertical direction fixation spring 524c becomes able to have a magnitude capable of resisting the suction force of the suction nozzle, it is possible to resist the suction force and prevent the uplift of the component feed tray 502 even when the component feed tray 502 is sucked and held by the erroneous suction of the suction nozzle. Although there has been described the case where the urging member is the vertical direction fixation spring 524c, it is also acceptable to employ an elastic member other than the spring in place of the above-mentioned case so long as the member can secure the urging function.

Next, a schematic sectional view of an X-axis fixation bar 534, which is one example of the fixation bar according to a second modification example of the present second embodiment, is shown in Fig. 18. As shown in Fig. 18, the X-axis fixation bar 534 is provided with a plurality of vertical direction fixation surfaces 534c, which serves as one example of a second direction fixation portion and as one example of a second direction fixation surface to fix the placement position of the component feed tray 502 in the direction perpendicular to the tray placement surface 504 by being brought in contact with the end portion 502a of the component feed tray 502. The vertical direction fixation surfaces 534c are formed at mutually different heights roughly parallel to the tray placement surface 504 and are able to come in contact with the end portion 502a of component feed trays 502 that have heights coinciding with the respective formation heights. Further, the X-axis fixation bar 534 is provided with a plurality of horizontal direction fixation surfaces 534a, which serve as one example of the first direction fixation portion and one example of the first direction fixation surface formed so as to individually correspond to the respective vertical direction fixation surfaces 534c and join the vertical direction fixation surfaces 534c that have mutually adjacent formation heights.

The horizontal direction fixation surfaces 534a are each formed so as to be roughly perpendicular to the tray placement surface 504 and able to fix the placement position of the component feed tray 502 to be brought in contact in the horizontal direction. As described above, the plurality of horizontal direction fixation surfaces 534a and the plurality of vertical direction fixation surfaces 534c are formed on the X-axis fixation bar 534, by which a plurality of step portions are formed of the mutually corresponding horizontal direction fixation surfaces 534a and vertical direction fixation surfaces 534c.

As shown in Fig. 18, the step portion confirming to the height of the end portion 502a of the component feed tray 502, i.e., the step portion confirming to the height position of contact with the end portion 502a is selected from among the plurality of step portions provided on the X-axis fixation bar 534, and the selected step portion is brought in contact with the end portion 502a. That is, the horizontal direction fixation surface 534a of the step portion is brought in contact with the end surface of the end portion 502a, while the vertical direction fixation surface 534c of the step portion is brought in contact with the upper surface of the end portion 502a. As a result, the placement position of the component feed tray 502 can be fixed in the horizontal direction and the vertical direction.

In forming the step portions, the step portions are required to be formed so that the areas of the horizontal direction fixation surfaces 534a and the vertical direction fixation surfaces 534c are able to achieve the fixation. For example, it is preferable to form the step portions so that the area of each vertical direction fixation surface 534c can resist the force that tries to uplift the component feed tray 502 caused by the erroneous suction of the suction nozzle.

Next, a schematic sectional view of an X-axis fixation bar 544, which is one example of the fixation bar according to a third modification example of the present second embodiment, is shown in Fig. 19. As shown in Fig. 19, the X-axis fixation bar 544 is provided with a horizontal direction fixation surface 544a, which serves as one example of the first direction fixation portion and as one example on the first direction fixation surface to fix the placement position of the component feed tray 502 in the direction along the tray placement surface 504 by being brought in contact with the end portion 502a of the component feed tray 502. Moreover, the X-axis fixation bar 544 is also provided with a vertical direction fixation portion 534c, which serves as one example of the second direction fixation portion and as one example on the second direction fixation surface to fix the placement position of the component feed tray 502 in the direction perpendicular to the tray placement surface 504.

As shown in Fig. 19, the vertical direction fixation portion 534c can be adjusted so as to vary the fixation height position thereof. Therefore, the height position of the vertical direction fixation portion 534c can be adjusted in accordance with the height of the end portion 502a of the component feed tray 502 of which the placement position is fixed, and various types of component feed trays 502 can be fixed.

Moreover, in the present second embodiment, there has been described the case where both the X-axis fixation bars 514 and the Y-axis fixation bars 516 have the built-in magnet sections and are able to be magnetically fixed on the tray placement surface 504. However, the present second embodiment is not limited to the above case but allowed to adopt fixation means of other fixation bars.

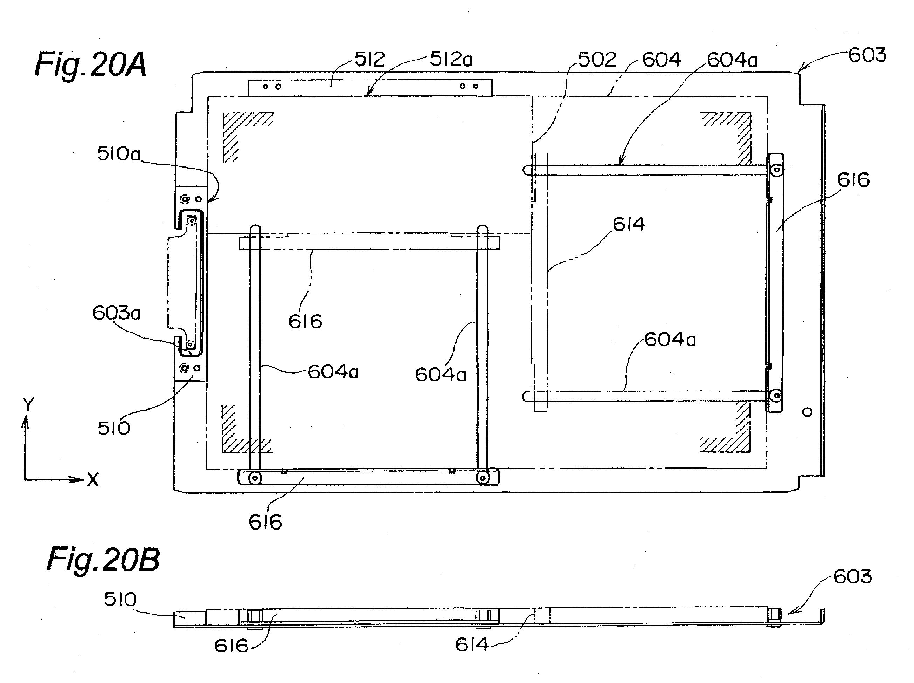

For example, as shown in the schematic plan view and the side view of the tray plate 603 of Figs. 20A and 20B, it is acceptable to provide a plurality of slot portions 604a on the tray placement surface 604 of the tray plate 603 and allow fixation bars 614 and 616 to be releasably fixed by means of screws or the like in arbitrary positions within the formation range of each of the slot portions 604a.

The above fixation means are effective means in that magnetic influence on the electronic components 501 can be prevented by the nonuse of magnetic fixation means when, for example, electronic components 501 that are apt to be easily damaged by magnetic influence, are arranged and accommodated in the component feed tray 502.

Moreover, there is a further advantage that, even when the force that tries to uplift the component feed tray 502 when the suction force of the suction nozzle is great and the component feed tray 502 is erroneously sucked by the suction nozzle becomes greater than the magnetic force of the magnet section 514b or the like, the mechanical force of the engagement of screws or the like with the slot portions 604a can resist the uplifting force, and the uplift of the component feed tray 502 can reliably be prevented.

According to the second embodiment, the following various effects can be obtained.

First of all, the X-axis fixation bar 514 and the Y-axis fixation bar 516 are provided with not only the function to fix the placement position of the component feed tray 502 placed on the tray placement surface 504 of the tray plate 503 in the direction (horizontal direction) along the surface of the tray placement surface 504 but also the function to concurrently fix the placement position in the direction (vertical direction) perpendicular to the tray placement surface 504. With this arrangement, the component feed tray 502 can be fixed in the horizontal direction and the vertical direction. Therefore, even when the component feed tray 502 is erroneously sucked by the suction nozzle, the occurrence of the uplift of the component feed tray 502 can be prevented beforehand by virtue of the fixation also in the vertical direction. Therefore, the leap-up and the occurrence of displacement of the electronic components 501 possibly occurring in accordance with the uplift of component feed tray 502 can be prevented beforehand, and efficient component mounting can be achieved.

In concrete, for example, the X-axis fixation bar 514 (likewise in the case of the Y-axis fixation bar) is provided with the fixation surface 514a that has a surface inclined with respect to the plane perpendicular to the tray placement surface 504. With this arrangement, the placement position of the component feed tray 502, which is brought in contact with this fixation surface 514a, can be concurrently fixed not only in the horizontal direction but also in the vertical direction. That is, the concurrent fixation can be achieved by the fixation surface 514a that is one inclined surface.

Moreover, by virtue of the fact that the fixation surface 514a is the inclined surface, there can be provided a fixation bar, which can cope with the fixation of component feed trays 502 provided with the end portions 502a having various configurations and has versatility.

Moreover, in the case where the inclination angle θ of the fixation surface 514a of the X-axis fixation bar 514 is gently inclined with respect to, for example, the plane perpendicular to the tray placement surface 504, the fixation bar can cope with the fixation of the component feed trays 502 of more various end configurations. Conversely, in the case where the surface is largely inclined with respect to the perpendicular plane, the fixation in the vertical direction can more reliably be achieved. As described above, in the case where the surface is largely inclined, the bar can be very effective for the fixation of a component feed tray 502 reduced in thickness. Therefore, by utilizing such a feature, an appropriate inclination angle θ can be set according to the configuration of the component feed tray 502, the fixation force and so on.

Moreover, when the X-axis fixation bars 524, 534 or 544 is provided with the vertical direction fixation spring 524c or provided with the plurality of step portions formed of the plurality of horizontal direction fixation surfaces 534a and the plurality of vertical direction fixation surfaces 534c or provided with the vertical direction fixation surface 544c of which the formation height is variable and adjustable, the bar can cope with the fixation of the component feed tray 502 that has various end configurations.

Moreover, by fixing the end portion 502a of the component feed tray 502 in the vertical direction by the X-axis fixation bar 514 or the like even when the component feed tray 502 is deformed and warped, the tray can be placed on the tray placement surface 504 in a state in which the warp is corrected. Therefore, even in this case, it becomes possible to achieve stable pickup of the electronic component 501 by the suction nozzle.

Moreover, by making the X-axis reference surface 510a of the X-axis reference member 510 and the Y-axis reference surface 512a of the Y-axis reference member 512 shown in Figs. 13A and 13B serve as inclined surfaces, the prevention of the uplift of the component feed tray 502 can be further assured.

(Third Embodiment)

The present invention is not limited to the aforementioned embodiments but allowed to be put into practice in various forms. For example, a method for picking up the components from the component feed tray by the electronic component feeding method according to a third embodiment of the present invention makes it possible to prevent the occurrence of the uplift of the component feed tray beforehand by correlating the elevation operation for the component pickup of the suction nozzle in the components feeder with the suction start timing of the suction nozzle for the achievement of appropriate timing.

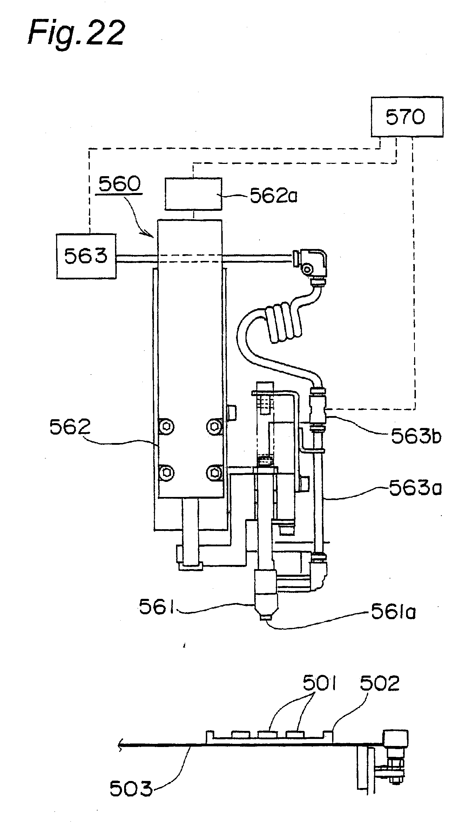

Fig. 22 shows a schematic side view showing the construction of a component mounting head 560 provided with a suction nozzle 561 of one example of the component suction and holding member for carrying out the suction and pickup of an electronic component as described above. It is to be noted that the component mounting head 560 is provided for the component mounting apparatus (not shown) in which the mounting of electronic components onto a circuit board is carried out and able to be moved in the direction along the upper surface of the machine base relatively to the circuit board, the component feed tray and so on arranged on the upper surface of the machine base of this component mounting apparatus. Moreover, by carrying out the movement operation, the electronic component picked up from the component feed tray can be moved to a place above the circuit board and mounted.

As shown in Fig. 22, the component mounting head 560 is provided with a suction nozzle 561 that releasably sucks and holds the electronic component 501, an elevation unit 562 that moves up or down this suction nozzle 561 and a vacuum suction unit 563 of one example of the suction unit for sucking and holding the electronic component 501 at the suction nozzle 561.

The suction nozzle 561 has its lower end provided with a suction section 561a that can suck and hold the electronic component 501 while being brought in contact with the electronic component 501. This suction section 561a is connected to the vacuum suction unit 563 via a connecting tube (or suction tube) 563a, and this connection allows the aforementioned suction and holding to be effected. A suction valve 563b, which is one example of the control valve that enables opening and closing control, is provided partway at this connecting tube 563a. This arrangement makes it possible to carry out the suction and holding of the electronic component 501 by a suction force generated at the suction section 561a by putting the suction valve 563b into an open state for the achievement of a state in which the suction section 561a and the vacuum suction unit 563 communicate with each other via the connecting tube 563a and to prevent the generation of the suction force at the suction section 561a by putting the suction valve 563b into a closed state for the achievement of a state in which the communication between the suction section 561a and the vacuum suction unit 563 via the connecting tube 563a is interrupted.

For the elevation unit 562, there can be employed a mechanism provided with a ball screw shaft section and a nut section meshed with the shaft section. By rotating the ball screw shaft section by means of a drive motor, the nut section in the meshing engagement can be moved up or down. By this operation, the suction nozzle 561 fixed to the nut section can be moved up or down. The elevation drive amount of the suction nozzle 561 can be controlled by, for example, controlling the rotational drive amount of the drive motor, and the range of the elevation operation, i.e., an upper limit and a lower limit are electrically or mechanically regulated. Moreover, the elevation unit 562 is provided with a speed controller 562a, which controls the lifting speed (time) and the lowering speed (time) of the suction nozzle 561.

Moreover, as shown in Fig. 22, the component mounting head 560 is provided with a control unit 570, which is able to supervisorily control the elevation operation of the suction nozzle 561 by the elevation unit 562, the speed control operation by the speed controller 562a, the vacuum suction operation by the vacuum suction unit 563 and the opening/closing operation of the suction valve 563b while correlating them. By controlling the operation timing of the elevation operation of the suction nozzle 561, the vacuum suction operation by the vacuum suction unit 563 and the opening/closing operation of the suction valve 563b while correlating them by means of the control unit 570, the electronic component 501 can be picked up by suction and holding.

Fig. 22 shows a state in which the aforementioned movement relative to the component mounting head 560 of the aforementioned construction is carried out, and the component mounting head 560 is located in a position above the component feed tray 502. It is to be noted that a plurality of electronic components 501 are arranged on the component feed tray 502 while being able to be picked up.

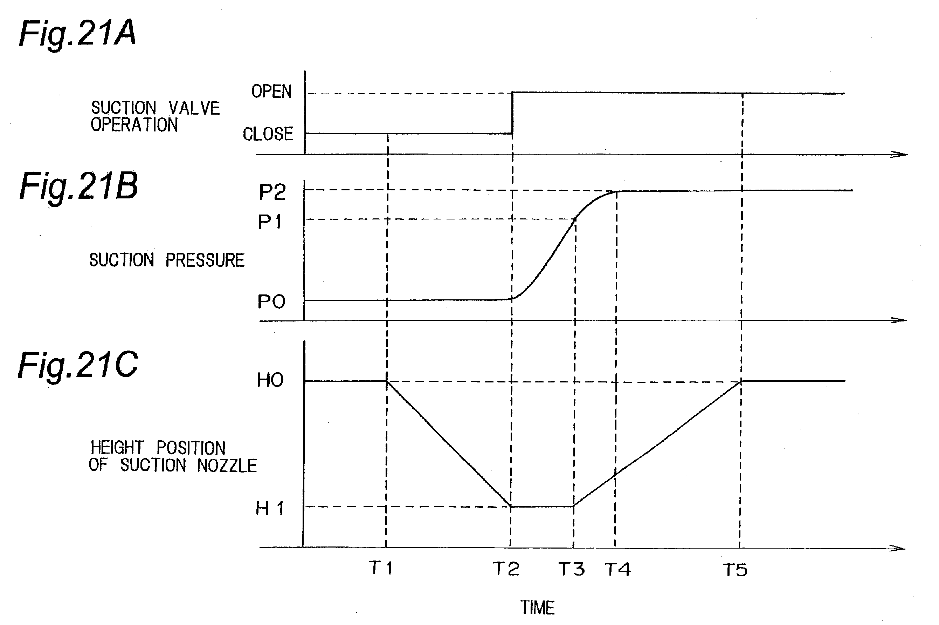

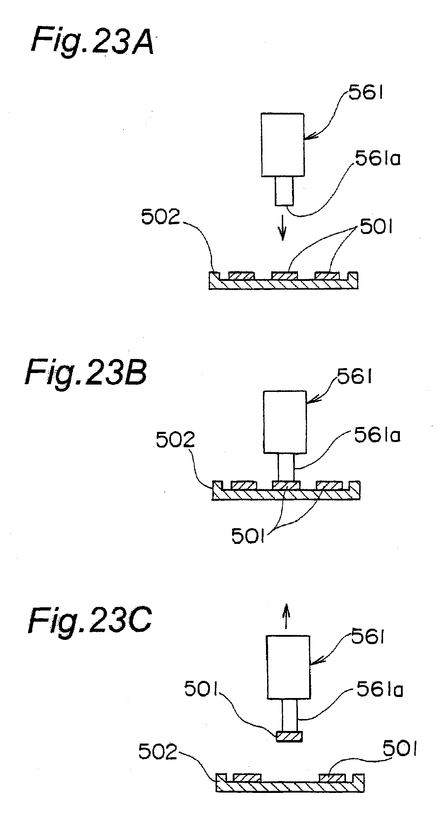

A method for carrying out the suction and pickup of the electronic component 501 arranged in the component feed tray 502 by means of the suction nozzle 561 provided for the component mounting head 560 as described above will be described next. Figs. 23A, 23B and Fig. 23C show schematic explanatory views, which schematically explain the operation of the suction nozzle 561 during the suction and pickup as described above. Figs. 21A through 21C show timing charts showing states of changes plotted on an identical time base (horizontal axis) with respect to the state of change of the opening/closing operation of the suction valve 563b during the suction and pickup (Fig. 21A), the state of change of the suction pressure for the suction and holding of the electronic component 501 in the suction section 561a (Fig. 21B) and the state of change of the height position (height position of the suction section 561a) due to the elevation operation of the suction nozzle 561 (Fig. 21C), which are plotted on the vertical axis. It is to be noted that the operations described below are executed while being supervisorily controlled through correlation by the control unit 570 provided for the component mounting head 560. In the timing chart of Fig. 21A, the operation of the suction valve 563b is indicated in either the open or closed state. In Fig. 21B, the magnitude of the suction pressure (suction force) generated in the suction section 561a is indicated by a state P0 in which no suction force is generated (e.g., a state in which the pressure is zero), a component holding and suction pressure P1 that is the minimum suction pressure necessary for the suction and holding of the electronic component 501 and a suction pressure P2 that is a pressure higher than the component holding and suction pressure P1 and for reliably stably carrying out the suction and holding of the electronic component 501. In Fig. 21C, the height position of the suction section 561a of the suction nozzle 561 is indicated by an upper end height position H0 within its elevation operation range and a height position in which the electronic component 501 can be sucked and held (i.e., height position in which the suction section 561a is brought in contact with the electronic component 501) H1. In Figs. 21A through 21C, remarkable time points of the pickup operation by the suction and holding are indicated by times T1 through T5.

As shown in Fig. 23A, positional alignment of one electronic component 501 among a plurality of electronic components 501 arranged in the component feed tray 502 with the suction nozzle 561 is carried out, and thereafter, descent operation of the suction nozzle 561 positioned in the upper end height position H0 is started at the time T1. At this time T1, the suction valve 563b is in the closed state, and the suction pressure still remains P0 in the suction section 561a.

Subsequently, when the suction nozzle 561 is lowered and the suction section 561a is positioned in the height position H1 at the time T2, the suction section 561a is brought in contact with the upper surface of the electronic component 501. This state is shown in Fig. 23B. In accordance with the contact, the suction valve 563b is opened, and consequently a rise in the suction pressure is started in the suction section 561a.

In due course, the suction pressure reaches the minimum component holding and suction pressure P1 necessary for sucking and holding the electronic component 1 at the time T3, with which the ascent of the suction nozzle 561 is started. Consequently, the electronic component 501 is lifted and picked up from the component feed tray 502 while the upper surface of the electronic component 501, brought in contact with the suction section 561a, is sucked and held by the suction section 561a with the suction pressure. This state is shown in Fig. 23C. Further, the rise in the suction pressure of the suction section 561a is subsequently continued, and the suction pressure reaches the suction pressure P2 at which reliable suction and holding can be stably achieved at the time T4.

Subsequently, the suction section 561a of the suction nozzle 561 is positioned in the upper end height position H0 with the electronic component 501 sucked and held at the time T5, and the component mounting head 560 is moved to a place above the circuit board by the aforementioned relative movement, and the mounting of the electronic component 501 is carried out.

Moreover, the component holding and suction pressure P1 generated in the suction section 561a of the suction nozzle 561 should preferably be set not lower than, for example, a suction pressure capable of sucking and holding the electronic component 501 and lower than a suction pressure capable of sucking and holding and uplifting the component feed tray 502. By thus setting the suction pressure, the component feed tray 502 cannot be uplifted even when the suction nozzle 561 sucks a portion where no electronic component 501 is arranged on the component feed tray 502. Therefore, the occurrence of the leap-up and so on of the electronic component 501 due to the occurrence of the uplift of the component feed tray 502 can be prevented beforehand.

Moreover, such the component holding and suction pressure P1 can be determined to an optimum value according to the states (size, configuration, weight, etc.) of the component feed tray 502 and the component 501. For example, in the case where a large-size component 501 that has a weight of 8 g and is placed on a component feed tray 502 that has a weight of about 100 to 300 g is sucked and held, the component holding and suction pressure P1 can be set to about 0.9 kPa. With this pressure, the safety factor is tenfold or more, and the suction and pickup of the component 501 can reliably be carried out while preventing the uplift of the component feed tray 502 due to erroneous suction.

Moreover, as shown in Figs. 21B and 21C, by starting the rise in the suction pressure by releasing the suction valve 563b at, for example, the time T2 when the suction nozzle 561 is brought in contact with the electronic component 501 so that the suction pressure reaches the component holding and suction pressure P1 capable of sucking and holding the electronic component 501 at the time T3 when the ascent of the suction nozzle 561 brought in contact with the upper surface of the electronic component 501 is started, the electronic component 501 can reliably be sucked and held at the time T3.

Moreover, this timing of starting the rise in the suction pressure can be determined in consideration of the time needed for the pressure's starting rising to reaching the component holding and suction pressure P1 capable of sucking and holding the electronic component 501. For example, by determining the start of rising the suction pressure in consideration of the time needed for the pressure's reaching the component holding and suction pressure P1 with reference to the time T3 of the start of the ascent of the suction nozzle 561, the time for the generation of the needless suction pressure can be shortened, and energy saving can be achieved. Moreover, by generating no suction pressure when no suction pressure is needed or, for example, during the descent operation of the suction nozzle 561 or the like, influences exerted on the members other than the electronic component 501 subjected to suction and holding due to the generation of the suction pressure can be reduced. For example, the erroneous suction of the component feed tray 502 and the occurrence of erroneous suction, displacement and so on of the other electronic components 501 by the suction nozzle 561 can be prevented beforehand. The timing of starting the rise in the suction pressure as described above should preferably be at, for example, the time point immediately before the time T2 when the suction nozzle 561 and the electronic component 501 are brought in contact with each other or after the time T2, and the desired timing can be determined according to the features of the component feed tray 502 and the size, weight and so on of the component 501.

For example, assuming that the time T1 is the reference time (zero second in time) in Figs. 21A through 21C, then the time T2, the time T3 and the time T5 can be 210 seconds, 260 seconds and 530 seconds, respectively. It is possible to start the release operation of the suction valve 563b to start rising the suction pressure at a time point after a lapse of 210 seconds from the time T1 while managing these times by the control unit 570. However, since a time lag might practically exist from a release operation start command to the actual release of the suction valve 563b, it is also possible to advance, for example, the timing of starting the release operation of the suction valve 563b by the above-mentioned time lag to a time point after a lapse of 200 seconds from the time T1. By determining the time point of each operation in consideration of the above-mentioned time lag, reliable suction and pickup of the electronic component 501 can be achieved.

Moreover, a time from the start of the descent of the suction nozzle 561 (i.e., suction command from the control unit 570) at the time T1 to the start of the rise in the suction pressure in the suction section 561a of the suction nozzle 561 can preparatorily be set by, for example, a timer or the like. By thus setting the above-mentioned time by means of a timer or the like, the time point (e.g., time T2 in Figs. 21A through 21C) of the start of rising the suction pressure can be adjusted so as to have the desired timing immediately before the time T2 or within the range of the time T2 to the time T3.

Furthermore, the speed of the descent operation of the suction nozzle 561 from the time T1 to the time T2 (i.e., the time needed for the descent operation) can be set to the desired condition by adjusting the setting of the speed controller 562a. In this case, the descent speed and the time needed for the descent of the suction nozzle 561 can be adjusted so as to alleviate impact and vibrations due to, for example, the suction nozzle 561 brought in contact with the component 501. By setting the descent speed late particularly when a small-size lightweight component 501 is sucked and picked up, the impact and vibrations can be alleviated, and the occurrence of the leap-up and so on of the components 501 can be prevented beforehand. Moreover, the descent speed and the time needed for the descent of the suction nozzle 561 may also be adjusted similarly.

According to the third embodiment, the component holding and suction pressure P1 generated in the suction section 561a of the suction nozzle 561 is set not lower than the suction pressure capable of sucking and holding the electronic component 501 and lower than the suction pressure capable of sucking and holding and uplifting the component feed tray 502. With this arrangement, the component feed tray 502 is not uplifted even when the suction nozzle 561 sucks the component feed tray 502. Therefore, the occurrence of the leap-up of the accommodated electronic component 501 can be prevented beforehand.

Moreover, by determining the timing of starting applying the aforementioned suction pressure by inverse operation with reference to the timing of starting the ascent of the suction nozzle 561 brought in contact with the upper surface of the electronic component 501, the occurrence of influences on the periphery due to the start of applying the suction pressure or, for example, the occurrence of the erroneous suction of the component feed tray 502, the occurrence of the erroneous suction of the surrounding electronic components 501 and so on can be prevented beforehand while assuring the achievement of the reliable suction and holding of the electronic component 501.

Therefore, reliable and stable suction and pickup of the electronic component can be achieved, and this allows the efficient component mounting to be achieved.

It is to be noted that the effects possessed by the aforementioned various embodiments can be produced by properly combining arbitrary ones of the embodiments.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

It follows a list of further embodiments of the invention:

Embodiment 1. An electronic component feeder (100) for loading a plurality of pallets (3, 3L, 3S) on each of which a component feed tray (2, 2L, 2S) for carrying a plurality of electronic components (1) arranged in alignment are placed in a plurality of stacked tiers, for feeding the electronic components on the component feed tray placed on a pallet unloaded from among the loaded pallets to an electronic component feed position (107) along a pallet feed direction (A), the feeder comprising:

a magazine (4, 4L, 4S), in which a plurality of pairs of support sections (14) for supporting mutually opposed edge portions (3c) of the pallets in a direction perpendicular to the pallet feed direction so that the pallets are supported roughly horizontally and movably in the pallet feed direction are formed at regular intervals in a stacking direction, for loading the pallets supported by the corresponding pairs of support sections;

a magazine receiver (5) for receiving the magazine elevatably, which has a pallet feed port (6) for allowing the pallets loaded in the magazine to be unloaded from inside the magazine to an electronic component feed position;

a magazine elevation unit (8) for driving elevation of the magazine inside the magazine receiver while allowing a selected pallet to be unloaded through the pallet feed port;

a forward-side regulating member (18) for regulating support positions of the pallets loaded in the magazine by the corresponding support sections by being brought in contact with an edge portion of the pallet on a forward side in the pallet feed direction;

a rearward-side regulating member (24), movable in the pallet feed direction, for regulating support positions of the pallets regulated by the forward-side regulating member by the corresponding support sections by being brought in contact with an edge portion of the pallet on a rearward side in the pallet feed direction; and

a horizontal posture regulating member (26), which is provided integrally with the magazine, for regulating the roughly horizontal support posture of the pallets so that the support posture of each of the pallets, whose edge portions are supported by the corresponding pairs of support sections, by being arranged between the pallets stacked in tiers in the magazine,

the pallets being formed so that configurations of a forward-side edge portion and a rearward-side edge portion in the pallet feed direction are formed differently, the feeder being able to detect inclusion of the pallet supported in a reversely directed support posture in the pallet feed direction in the magazine on the basis of the regulation position of the pallet by the rearward-side regulating member, and the feeder being able to detect inclusion of the pallet in a support posture supported by support sections that are not mutually opposed in the magazine by means of the horizontal position regulating member.

Embodiment 2. The electronic component feeder with the features of embodiment 1, wherein

the magazine is provided with a magazine door section (22) which is an openable door provided on the rearward side in the pallet feed direction for feeding and loading the pallets from the rearward side and on the inside of which the rearward-side regulating member and the horizontal posture regulating member are fixed,

wherein the rearward-side regulating member can limit closing of the magazine door section by bringing in contact with the edge portion of the pallet supported in the reversely directed support posture, the magazine door section can be closed in a position where the rearward-side regulating member is brought in contact with the edge portion of the pallet supported in a forwardly directed support posture in the pallet feed direction,

the horizontal posture regulating member can limit closing of the magazine door section by bringing in contact with the edge portion of the pallet supported by the support sections that are not mutually opposed, the magazine door section can be closed by inserting the horizontal posture regulating member between the pallets supported by the pair of support sections, and

inclusion of the pallet that has abnormality in its support posture in the magazine can be detected by the limitation of the closing of the magazine door section.

Embodiment 3. The electronic component feeder with the features of embodiment 2, further comprising:

a door opening/closing detector (28, 29) for detecting the open state or the closed state of the magazine door section; and

a door opening and closing display section (19) for displaying a detection result by the door opening/closing detector while allowing an operator to recognize the result.

Embodiment 4. The electronic component feeder with the features of embodiment 3, wherein

the magazine receiver has a receiver door section (20) that is an openable door provided on the rearward side in the pallet feed direction, for being closed in a state in which its inside (25) is brought in contact with outside of the magazine door section in the closed state, for being limited its closing by bringing in contact with the outside of the magazine door section to limit the closing.

Embodiment 5. The electronic component feeder with the features of embodiment 4, wherein the door opening/ closing detector (28) is provided for the receiver door section.

Embodiment 6. The electronic component feeder with the features of embodiment 3, further comprising a control unit (9) for stopping driving operation of the magazine elevation unit when the open state of the magazine door section is detected by the door opening/closing detector.

Embodiment 7. The electronic component feeder with the features of embodiment 2, wherein the horizontal posture regulating member is provided with a plurality of projections (26a) which are formed arranged in the stacking direction at the same intervals as the intervals of the support sections, for being inserted in gaps between the pallets supported by the pair of support sections, for being limited to insert in the gaps by bringing in contact with the edge portion of the pallets supported by the support sections that are not mutually opposed.

Embodiment 8. The electronic component feeder with the features of embodiment 7, wherein the horizontal posture regulating member is fixed on the magazine door section so that the projections are arranged in positions located closer to either one of the support sections away from a possible intermediate between the mutually opposed support sections in a state in which the magazine door section is closed.

Embodiment 9. The electronic component feeder with the features of embodiment 8, wherein the projections are arranged so that any of the projections interferes with the pallet supported by the support sections which include the other support section displaced by at least one step in the stacking direction with respect to the support section opposed to one support section.

Embodiment 10. The electronic component feeder with the features of embodiment 1, wherein

each of the pallets has a pallet unloading grip portion (3d), which has a roughly rectangular shape and is formed roughly in a protruding configuration at an edge portion (3a) located on the forward side in the pallet feed direction, and the rearward-side regulating member is arranged so as to be able to come in contact with the grip portion of the pallet supported in the reversely directed support posture by the support sections.

Embodiment 11. The electronic component feeder with the features of embodiment 7, wherein the projections of the horizontal posture regulating member have a length dimension such that the projections do not reach a place above an arrangement region of the electronic components on the component feed tray placed on each of the pallets in a state in which the projections are inserted in gaps between the pallets.

Embodiment 12. The electronic component feeder with the features of embodiment 1, wherein

the feeder further comprises a component feed tray fixation bar (514, 516, 524, 534, 544, 614, 616) for fixing the component feed tray releasably on a placement surface (504, 604) of the pallet, and
the fixation bar comprising:

a first direction fixation portion (514a, 524a, 534a, 544a), for releasably fixing its arrangement position on the placement surface, for releasably fixing the placement position of the component feed tray in a first direction (X- or Y-direction) that is a direction along the placement surface by being brought in contact with the component feed tray placed on the placement surface; and
a second direction fixation portion (514a, 524c, 534c, 544c), for releasably fixing its arrangement position on the placement surface, for releasably fixing the placement position in a second direction that is a direction roughly perpendicular to the placement surface by being brought in contact with the component feed tray.

Embodiment 13. The electronic component feeder with the features of embodiment 12, wherein, with regard to the component feed tray fixation bar,
the first direction fixation portion is the first direction fixation surface (534a, 544a) formed roughly perpendicular to the placement position where the placement position is fixed in the first direction by being brought in contact with an end portion (502a) of the component feed tray, and
the second direction fixation portion is the second direction fixation surface (534c, 544c) formed roughly perpendicular to the placement position where the placement position is fixed in the second direction by being brought in contact with an end portion of the component feed tray.

Embodiment 14. The electronic component feeder with the features of embodiment 13, wherein, with regard to the component feed tray fixation bar,
a height position of the second direction fixation surface (544c) brought in contact with the edge portion of the component feed tray is adjustable in the second direction.

Embodiment 15. The electronic component feeder with the features of embodiment 12, wherein, with regard to the component feed tray fixation bar,
the fixation bar (524) is provided with an urging member (524c) that always urges the second direction fixation portion toward the end portion of the component feed tray.

Embodiment 16. The electronic component feeder with the features of embodiment 13, wherein, with regard to the component feed tray fixation bar,
the fixation bar (534) comprising:

a plurality of the second direction fixation surfaces (534c) formed at different height levels; and
a plurality of the first direction fixation surfaces (534a) individually corresponding to the second direction fixation surfaces, and
the placement position of the component feed tray is fixed by the second direction fixation surface that conforms to the height of the end portion of the component feed tray and belongs to the second direction fixation surfaces and the first direction fixation surface that corresponds to the second direction fixation surface.

**Claims**

1. An electronic component feeding method for feeding a plurality of electronic components (501) to be mounted on a board by carrying out suction and holding and pickup of the electronic components from a component feed tray (502) in which the electronic components are arranged while being able to be sucked and picked up by a component suction and holding member (561) capable of sucking and holding each of the components with its suction pressure, the component suction and holding member carrying out the suction and holding and pickup of each of the electronic components with a component holding and suction pressure (P1) which is a suction pressure that is not lower than a suction pressure capable of sucking and holding the electronic component and lower than a suction pressure capable of sucking and holding the component feed tray.

2. The electronic component feeding method as claimed in claim 1, wherein:

bringing the component suction and holding member in contact with the electronic component by lowering the component suction and holding member after aligning in position the component feed tray with the component suction and holding member;
starting suction by the component suction and holding member so that the suction pressure reaches the component holding and suction pressure when the component suction and holding member brought in contact with the electronic component starts ascending; and

carrying out the suction and holding and pickup of the electronic component with the ascent of the component suction and holding member.

3. The electronic component feeding method as claimed in claim 2, wherein a timing of starting the suction is determined in consideration of a time for which the suction pressure reaches the component holding and suction pressure from the start of the suction by the component suction and holding member.

4. The electronic component feeding method as claimed in claim 2, wherein starting the suction by the component suction and holding member after the component suction and holding member is brought in contact with the electronic component.

5. The electronic component feeding method as claimed in claim 2, wherein the time for lowering the component suction and holding member is determined according to a size or a weight of the electronic component so as to prevent leap-up of the electronic component from the component feed tray due to the component suction and holding member brought in contact with the electronic component.

6. The electronic component feeding method as claimed in any one of claims 1 through 5, wherein the component holding and suction pressure is a suction pressure determined according to a size or a weight of the electronic component.

*Fig.1*

EP 1 746 874 A2

# Fig.2

*Fig. 3*

*Fig. 4*

Fig. 5

EP 1 746 874 A2

**Fig. 6**

*Fig. 7A*

*Fig. 7B*

## Fig. 8A

## Fig. 8B

Fig. 9

EP 1 746 874 A2

Fig. 10

EP 1 746 874 A2

*Fig. 11*

*Fig. 12*

EP 1 746 874 A2

*Fig.13A*

EP 1 746 874 A2

*Fig.13B*

*Fig.14A*

*Fig.14B*

EP 1 746 874 A2

EP 1 746 874 A2

*Fig.15*

*Fig.16*

42

*Fig.17*

502a
524c
502    524c
            524
                524b

504  524a

*Fig.18*

534c  534a        534
                    534b

502  502a
   504

*Fig.19*

544c        544
              544b

502

502a  544a    504

*Fig.20A*

512   512a       502   604   604a       603

510a

616

603a       614

510       616       604a   604a

X   Y

616

*Fig.20B*

603

510

616       614

EP 1 746 874 A2

## Fig.21A

SUCTION VALVE
OPERATION

OPEN

CLOSE

## Fig.21B

SUCTION PRESSURE

P2
P1

P0

## Fig.21C

HEIGHT POSITION
OF SUCTION NOZZLE

H0

H1

T1    T2    T3  T4    T5

TIME

EP 1 746 874 A2

*Fig.22*

*Fig.23A*

*Fig.23B*

*Fig.23C*

*Fig.24*

*Fig.25*

*Fig.26*

## Fig.27

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11121985 A

- JP 10335889 A